# EUROPEAN PATENT SPECIFICATION

(11) **EP 4 435 862 B1**
(45) Date of publication and mention of the grant of the patent: **18.11.2026**
(21) Application number: 24165007.6
(22) Date of filing: 21.03.2024
(51) Int. Cl.: H10D 86/40, H10D 86/60

(54) **DISPLAY APPARATUS**
ANZEIGEGERÄT
APPAREIL D'AFFICHAGE

(30) Priority: 24.03.2023 KR 20230039178; 01.08.2023 KR 20230100698
(43) Date of publication of application: 25.09.2024
(73) Proprietor: Samsung Display Co., Ltd., Yongin-si, Gyeonggi-do 17113 (KR)
(72) Inventor: Kim, Sunghwan, 17113 Yongin-si, Gyeonggi-do (KR); Kwak, Wonkyu, 17113 Yongin-si, Gyeonggi-do (KR); Moon, Joongsoo, 17113 Yongin-si, Gyeonggi-do (KR); Cho, Youngjin, 17113 Yongin-si, Gyeonggi-do (KR); Shin, Heyjin, 17113 Yongin-si, Gyeonggi-do (KR); Jin, Changkyu, 17113 Yongin-si, Gyeonggi-do (KR)
(74) Representative: Gulde & Partner

(56) References cited:
- CN-A- 106 024 838
- US-A1- 2019 348 449
- US-A1- 2020 168 638
- US-A1- 2021 126 022
- US-A1- 2022 310 736

## Description

### BACKGROUND

### 1. Field

One or more embodiments relate to a structure of a display apparatus, and more particularly to a structure of a display apparatus having a high-quality image.

### 2. Description of the Related Art

Display apparatuses visually display data. A display apparatus may include a substrate divided into a display area and a peripheral area. In the display area, a scan line and a data line that is insulated from each other may be formed, and a plurality of pixels may be included. Also, in the display area, a thin-film transistor corresponding to each of the pixels and a pixel electrode electrically connected to the thin-film transistor may be provided. Also, in the display area, a counter electrode commonly provided for the pixels may be provided. In the peripheral area, various wirings for transmitting electrical signals to the display area, a scan driving unit, a data driving unit, a control unit, and a pad unit may be provided.

Display apparatuses have been used for various purposes. Examples may be found in CN 106 024 838 A or US 2020/168638 A1. Accordingly, various designs have been attempted to improve the quality of display apparatuses.

### SUMMARY

The invention is defined by the appended claims. The description that follows is subjected to this limitation. Any disclosure lying outside the scope of said claims is only intended for illustrative as well as comparative purposes. One or more embodiments include a display apparatus capable of displaying a high-quality image and reducing costs. However, the embodiments do not limit the scope of the invention.

According to one or more embodiments, a display apparatus includes a substrate including a display area and a peripheral area surrounding the display area, a first silicon-based transistor located on the substrate, and including a first semiconductor layer including a silicon semiconductor and a first gate electrode insulated from the first semiconductor layer, a first oxide-based transistor located on the substrate, and including a second semiconductor layer including an oxide semiconductor and a second gate electrode insulated from the second semiconductor layer, and a first gate insulating layer located on the first semiconductor layer and the second semiconductor layer, wherein the first gate electrode and the second gate electrode are located on the first gate insulating layer and are located on substantially a same layer.

According to a preferred embodiment, the first silicon-based transistor may be located in the peripheral area of the substrate, and the first oxide-based transistor may be located on the display area of the substrate.

In an embodiment, the display apparatus may further include an insulating layer located between the first semiconductor layer and the second semiconductor layer.

In an embodiment, the insulating layer and the first gate insulating layer may be located between the first semiconductor layer and the first gate electrode, and only the first gate insulating layer may be located between the second semiconductor layer and the second gate electrode.

In an embodiment, the first semiconductor layer and the second semiconductor layer may be located on substantially a same layer.

In an embodiment, only the first gate insulating layer may be located between the first semiconductor layer and the first gate electrode, and only the first gate insulating layer may be located between the second semiconductor layer and the second gate electrode.

The display apparatus further includes a driving circuit located in the peripheral area, and a pixel circuit located in the display area.

The driving circuit includes the first silicon-based transistor, and the pixel circuit includes the first oxide-based transistor.

The display apparatus further includes a first storage electrode integrally formed with the second gate electrode, a second gate insulating layer covering the first gate electrode and the second gate electrode, and a second storage electrode formed on the second gate insulating layer and overlapping the first storage electrode, wherein the pixel circuit further includes a storage capacitor including the first storage electrode and the second storage electrode.

The display apparatus further includes a first hold electrode formed on substantially a same layer as the second storage electrode, and a second hold electrode formed on substantially a same layer as the second gate electrode, wherein the pixel circuit further includes a hold capacitor including the first hold electrode and the second hold electrode.

In an embodiment (not falling under the protection scope of the present invention), the pixel circuit may further include a second silicon-based transistor including a third semiconductor layer including a silicon semiconductor and a third gate electrode insulated from the third semiconductor layer, wherein the third semiconductor layer is located on substantially a same layer as the first semiconductor layer, and the third gate electrode is located on substantially a same layer as the first gate electrode and the second gate electrode.

In an embodiment (not falling under the protection scope of the present invention), the display apparatus may further include a first storage electrode integrally formed with the third gate electrode, a second gate insulating layer covering the first gate electrode, the second gate electrode, and the third gate electrode, and a second storage electrode formed on the second gate insulating layer and overlapping the first storage electrode, wherein the pixel circuit further includes a storage capacitor including the first storage electrode and the second storage electrode.

In an embodiment (not falling under the protection scope of the present invention), the display apparatus may further include a first boost electrode formed on a same layer as the second gate electrode and the third gate electrode, and a second boost electrode integrally formed with the second semiconductor layer and overlapping the first boost electrode, wherein the pixel circuit further includes a boost capacitor including the first boost electrode and the second boost electrode.

In an embodiment (not falling under the protection scope of the present invention), the driving circuit may further include a buffer transistor, wherein the buffer transistor includes a buffer semiconductor layer and a control electrode, wherein the buffer semiconductor layer is located on substantially a same layer as the first semiconductor layer, and the control electrode is located on substantially a same layer as the first gate electrode and the second gate electrode.

According to one or more embodiments (not falling under the protection scope of the present invention), a display apparatus includes a substrate including a display area and a peripheral area surrounding the display area, a pixel circuit located in the display area, a display element connected to the pixel circuit, a driving circuit located in the peripheral area, a first pixel transistor included in the pixel circuit, and including a first pixel semiconductor layer including an oxide semiconductor and a first pixel gate electrode insulated from the first pixel semiconductor layer, a first peripheral transistor included in the driving circuit, and including a first peripheral semiconductor layer including a silicon semiconductor and a first peripheral gate electrode insulated from the first peripheral semiconductor layer, and a first gate insulating layer located on the first pixel semiconductor layer and the first peripheral semiconductor layer, wherein the first pixel gate electrode and the first peripheral gate electrode are located on the first gate insulating layer and are located on substantially a same layer.

In an embodiment (not falling under the protection scope of the present invention), the display apparatus may further include an insulating layer located between the first pixel semiconductor layer and the first peripheral semiconductor layer.

In an embodiment (not falling under the protection scope of the present invention), the insulating layer and the first gate insulating layer may be located between the first peripheral semiconductor layer and the first peripheral gate electrode, and only the first gate insulating layer may be located between the first pixel semiconductor layer and the first pixel gate electrode.

In an embodiment (not falling under the protection scope of the present invention), the first pixel semiconductor layer and the first peripheral semiconductor layer may be located on substantially a same layer.

In an embodiment, only the first gate insulating layer may be located between the first pixel semiconductor layer and the first pixel gate electrode, and only the first gate insulating layer may be located between the first peripheral semiconductor layer and the first peripheral gate electrode.

In an embodiment (not falling under the protection scope of the present invention), the pixel circuit may further include a second pixel transistor including a second pixel semiconductor layer including a silicon semiconductor and a second pixel gate electrode insulated from the second pixel semiconductor layer, wherein the second pixel semiconductor layer is located on substantially a same layer as the first peripheral semiconductor layer, and the second pixel gate electrode is located on substantially a same layer as the first pixel gate electrode and the first peripheral gate electrode.

In an embodiment (not falling under the protection scope of the present invention), the driving circuit may further include a buffer transistor, wherein the buffer transistor includes a buffer semiconductor layer and a control electrode, wherein the buffer semiconductor layer is located on substantially a same layer as the first peripheral semiconductor layer, and the control electrode is located on substantially a same layer as the first peripheral gate electrode and the first pixel gate electrode.

### BRIEF DESCRIPTION OF THE DRAWINGS

The above and other aspects, features, and advantages of certain embodiments will be more apparent from the following description taken in conjunction with the accompanying drawings, in which:
FIG. 1 is a plan view schematically illustrating a display apparatus, according to an embodiment;
FIG. 2 is a plan view schematically illustrating a display apparatus, according to an embodiment;
FIG. 3 is an equivalent circuit diagram schematically illustrating an organic light-emitting diode located in a display area of a display apparatus and a pixel circuit electrically connected to the organic light-emitting diode, according to an embodiment;
FIG. 4 is a layout view schematically illustrating a layout of an area A of the display apparatus of FIG. 2, according to an embodiment;
FIG. 5 is a layout view schematically illustrating a layout of an area B of the display apparatus of FIG. 2, according to an embodiment;
FIG. 6 is a cross-sectional view schematically illustrating parts of a display apparatus, according to an embodiment;
FIG. 7 is a cross-sectional view schematically illustrating a part of a display apparatus, according to another embodiment;
FIG. 8 is an equivalent circuit diagram schematically illustrating an organic light-emitting diode located in a display area of a display apparatus and a pixel circuit electrically connected to the organic light-emitting diode, according to another embodiment;
FIG. 9 is a layout view schematically illustrating a layout of a part of a display area of a display apparatus, according to another embodiment (not falling under the protection scope of the present invention);
FIG. 10 is a cross-sectional view schematically illustrating parts of a display apparatus, according to another embodiment (not falling under the protection scope of the present invention); and
FIG. 11 is a cross-sectional view schematically illustrating parts of a display apparatus, according to another embodiment (not falling under the protection scope of the present invention).

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the invention. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the invention allows for various changes and numerous embodiments, certain embodiments will be illustrated in the drawings and described in the detailed description. Effects and features of the invention, and methods for achieving them will be clarified with reference to embodiments described below in detail with reference to the drawings. However, the invention is not limited to the following embodiments and may be embodied in various forms.

Reference will now be made in detail to embodiments, examples of which are illustrated in the accompanying drawings, and in the drawings, the same elements are denoted by the same reference numerals, and thus a repeated description thereof will be omitted.

Although the terms "first," "second," etc. may be used to describe various elements, these elements should not be limited by these terms. These terms are only used to distinguish one element from another.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

It will be further understood that the terms "comprises" or "comprising" used herein specify the presence of stated features or components, but do not preclude the presence or addition of one or more other features or components.

It will be further understood that, when a layer, region, or component is referred to as being "on" another layer, region, or component, it may be directly on the other layer, region, or component, or may be indirectly on the other layer, region, or component with intervening layers, regions, or components therebetween.

Sizes of components in the drawings may be exaggerated or reduced for convenience of explanation. For example, because sizes and thicknesses of elements in the drawings are arbitrarily illustrated for convenience of explanation, the invention is not limited thereto.

When a certain embodiment may be implemented differently, a specific process order may be different from the described order. For example, two consecutively described processes may be performed substantially at the same time or may be performed in an order opposite to the described order.

It will be understood that when a layer, region, or component is referred to as being "connected," the layer, the region, or the component may be directly connected or may be indirectly connected with intervening layers, regions, or components therebetween. For example, when layers, regions, or components are referred to as being "electrically connected," the layers, the regions, or the components may be directly electrically connected, or may be indirectly electrically connected with intervening layers, regions, or components therebetween.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

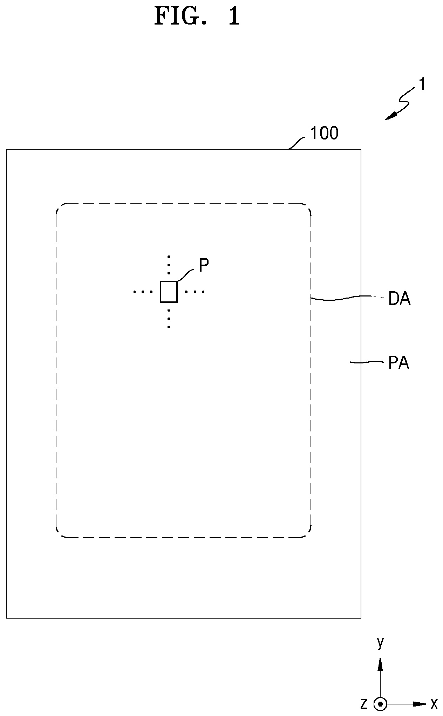

FIG. 1 is a plan view schematically illustrating a display apparatus, according to an embodiment.

In an embodiment and referring to FIG. 1, a display apparatus 1 includes a display area DA where an image is displayed and a peripheral area PA located around the display area DA. The display apparatus 1 may provide an image to the outside by using light emitted from the display area DA. Because the display apparatus 1 includes a substrate 100, the substrate 100 may include the display area DA and the peripheral area PA.

In an embodiment, the substrate 100 may include any of various materials, for example, glass, metal, and/or plastic. According to an embodiment, the substrate 100 may include a flexible material. The flexible material may refer to a material that is well bendable, foldable, and/or rollable. The substrate 100 including the flexible material may include ultra-thin glass, metal, and/or plastic.

In an embodiment, pixels P, including various display elements such as light-emitting diodes, may be located in the display area DA of the substrate 100. The light-emitting diode may be an organic light-emitting diode including an organic emission layer. Alternatively, the light-emitting diode may be a light-emitting diode including an inorganic emission layer. A size of the light-emitting diode may be a micro scale or a nano scale. For example, the light-emitting diode may be a micro light-emitting diode. Alternatively, the light-emitting diode may be a nanorod light-emitting diode. The nanorod light-emitting diode may include gallium nitride (GaN). In an embodiment, a color conversion layer may be located on the nanorod light-emitting diode. The color conversion layer may include quantum dots. Alternatively, the light-emitting diode may be a quantum dot light-emitting diode including a quantum dot emission layer. The pixels P may be disposed in any of various arrangements such as a stripe arrangement, a pentile arrangement, or a mosaic arrangement, to display an image.

In an embodiment, although the display area DA has a rectangular planar shape in FIG. 1, in another embodiment, the display area DA may have a polygonal shape such as a triangular shape, a pentagonal shape, or a hexagonal shape, a circular shape, an elliptical shape, or an irregular shape.

In an embodiment, the peripheral area PA of the substrate 100 located around the display area DA may be an area where an image is not displayed. Various wirings for transmitting an electric signal to be applied to the display area DA, and pads to which a printed circuit board or a driver integrated circuit (IC) chip is attached may be located in the peripheral area PA.

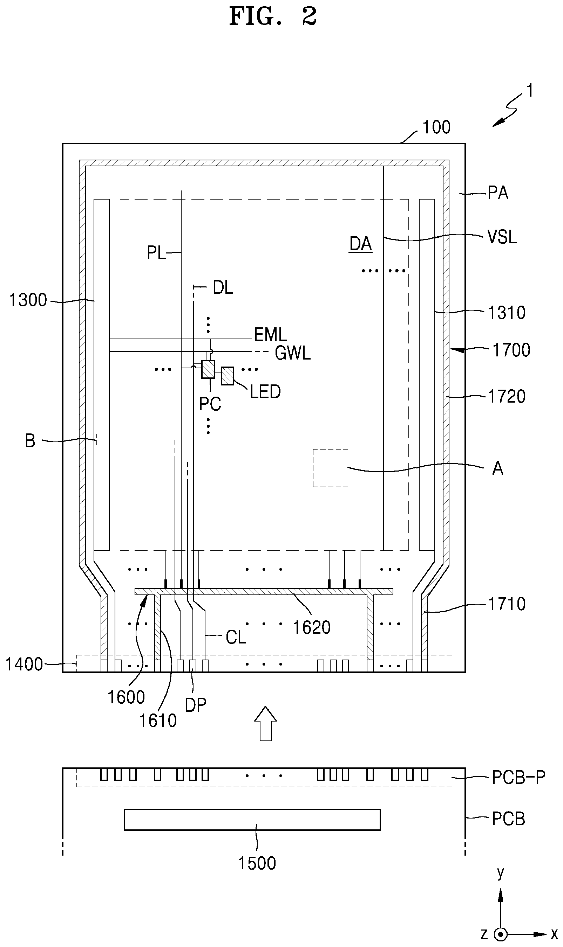

FIG. 2 is a plan view schematically illustrating a display apparatus, according to an embodiment.

In an embodiment and referring to FIG. 2, the display apparatus 1 may include light-emitting diodes LED located in the display area DA and a pixel circuit PC electrically connected to each of the light-emitting diodes LED. The light-emitting diodes LED and the pixel circuits PC may be arranged in a first direction (e.g., a ±x direction) and a second direction (e.g., a ±y direction) in the display area DA. The pixel circuits PC may be electrically connected to scan lines GWL, emission control lines EML, data lines DL, and driving voltage lines PL located in the display area DA.

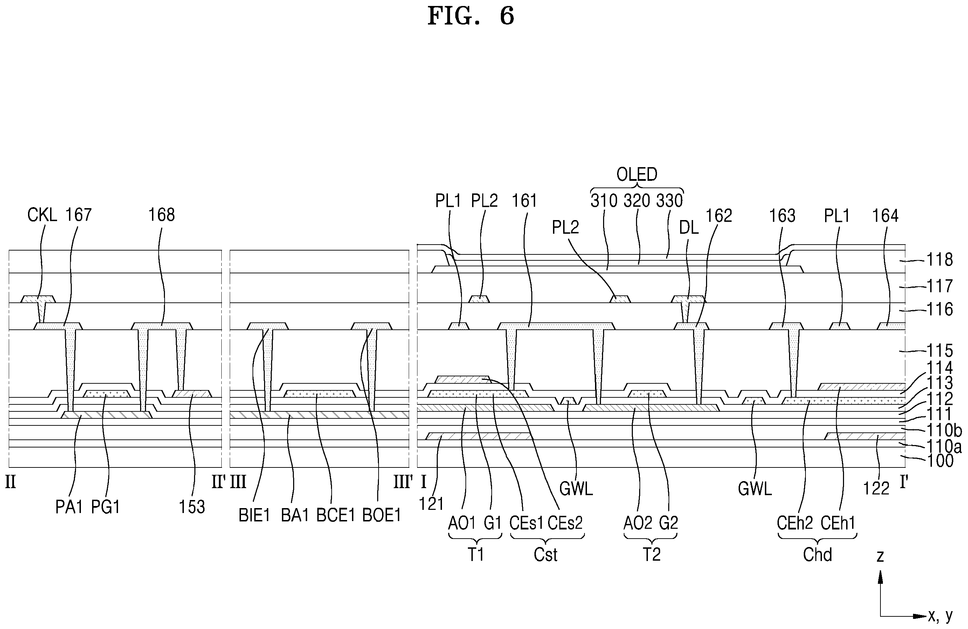

In an embodiment, the light-emitting diode LED may be an organic light-emitting diode OLED (see FIG. 6). In another embodiment, the light-emitting diode LED may be an inorganic light-emitting diode including an inorganic material. The inorganic light-emitting diode may include a PN junction diode including inorganic semiconductor-based materials. When a voltage is applied to a PN junction diode in a forward direction, holes and electrons may be injected, and energy generated by recombination of the holes and electrons may be converted into light energy to emit light of a certain color. The inorganic light-emitting diode may have a width of several to hundreds of micrometers, or several to hundreds of nanometers. Although an emission layer of the light-emitting diode LED may include an organic material or an inorganic material, in another embodiment, the emission layer of the light-emitting diode LED may include quantum dots. In other words, the light-emitting diode LED may be a quantum dot light-emitting diode.

In an embodiment, each of the scan lines GWL and the emission control lines EML may extend in the first direction (e.g., the ±x direction) and may be electrically connected to the pixel circuits PC located in the same row. Each of data lines DL and the driving voltage lines PL may extend in the second direction (e.g., the ±y direction) and may be electrically connected to the pixel circuits PC located in the same column.

In an embodiment, the display apparatus 1 may include a first driving circuit unit 1300, a second driving circuit unit 1310, a first voltage supply wiring 1600, a second voltage supply wiring 1700, and a pad unit 1400 located in the peripheral area PA.

In an embodiment, each of the first driving circuit unit 1300 and the second driving circuit unit 1310 may include a scan driving circuit, a gate driving circuit, and an emission control driving circuit. The scan driving circuit may provide a scan signal to each pixel circuit PC through the scan line GWL. The gate driving circuit may provide a compensation signal or an initialization signal to each pixel circuit PC through a compensation gate line (not shown or an initialization gate line (not shown). The emission control driving circuit may provide an emission control signal to each pixel circuit PC through the emission control line EML.

In an embodiment, the second driving circuit unit 1310 may be located parallel to the first driving circuit unit 1300 with the display area DA therebetween. Some of the pixel circuits PC located in the display area DA may be electrically connected to the first driving circuit unit 1300 and the rest may be connected to the second driving circuit unit 1310. In another embodiment, the second driving circuit unit 1310 may be omitted.

In an embodiment, the first voltage supply wiring 1600 and the second voltage supply wiring 1700 may be located in the peripheral area PA. The first voltage supply wiring 1600 may include a first sub-wiring 1610 extending in the second direction (e.g., the y axis direction) toward an end of the substrate 100 and a second wiring 1620 extending parallel to a first side of the display area DA. The second voltage supply wiring 1700 may have a loop shape with one side open and may partially surround the display area DA. The second voltage supply wiring 1700 may include a first sub-wiring 1710 extending in the second direction (e.g., the y axis direction) toward an end of the substrate 100 and a second sub-wiring 1720 extending along a second side, a third side, and a fourth side of the display area DA.

In an embodiment, the pad unit 1400 may be located on a side of the peripheral area PA. The pad unit 1400 may include a plurality of pads such as a data pad DP. The pad unit 1400 may be exposed without being covered by an insulating layer and may be electrically connected to a printed circuit board PCB. The pads of the pad unit 1400 may be electrically connected to a terminal unit PCB-P of the printed circuit board PCB. The printed circuit board PCB may transmit a signal and/or a voltage of a control unit (not shown) to a display panel.

In an embodiment, a control signal generated by the control unit may be transmitted to the first driving circuit unit 1300 and the second driving circuit unit 1310 through the printed circuit board PCB and the pad unit 1400.

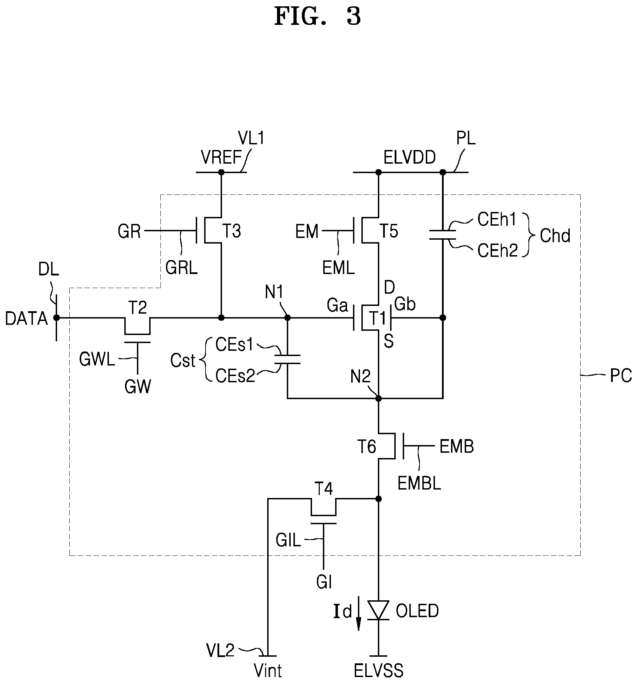

In an embodiment, a driving voltage ELVDD (see FIG. 3) generated by the control unit may be transmitted to the first voltage supply wiring 1600 through the first sub-wiring 1610 connected to the pads of the pad unit 1400. The driving voltage ELVDD may be provided to each pixel circuit PC through the driving voltage line PL connected to the first voltage supply wiring 1600.

In an embodiment, a common voltage ELVSS (see FIG. 3) generated by the control unit may be transmitted to the second voltage supply wiring 1700 through the first sub-wiring 1710 connected to the pads of the pad unit 1400. The common voltage ELVSS may be provided to a cathode (or a counter electrode) of the light-emitting diode LED connected to the second voltage supply wiring 1700. Common voltage lines VSL electrically connected to the second voltage supply wiring 1700 may be located in the display area DA. The common voltage lines VSL may prevent a voltage drop of the common voltage ELVSS which may occur as the area of the display area DA increases.

In an embodiment, a data driving circuit 1500 may be electrically connected to the data lines DL. A data signal (or a data voltage) of the data driving circuit 1500 may be provided to each pixel circuit PC through a connection line CL connected to the data pad DP of the pad unit 1400 and the data line DL connected to the connection line CL.

Although, in an embodiment the data driving circuit 1500 is located on the printed circuit board PCB in FIG. 2, in another embodiment, the data driving circuit 1500 may be located on the substrate 100. For example, the data driving circuit 1500 may be located between the pad unit 1400 and the first voltage supply wiring 1600.

FIG. 3 is an equivalent circuit diagram schematically illustrating an organic light-emitting diode located in a display area of a display apparatus 1 and a pixel circuit electrically connected to the organic light-emitting diode, according to an embodiment.

In an embodiment and referring to FIG. 3, the pixel P (see FIG. 1) may include an organic light-emitting diode OLED as a display element and a pixel circuit PC connected to the organic light-emitting diode OLED. The pixel circuit PC may include first to sixth transistors T1, T2, T3, T4, T5, and T6, respectively, and capacitors (e.g., Cst and Chd). The first transistor T1 may be a driving transistor that outputs driving current corresponding to a data signal, and the second to sixth transistors T2, T3, T4, T5, and T6, respectively, may be switching transistors that transmit signals. A first terminal (first electrode) of each of the first to sixth transistors T1, T2, T3, T4, T5, and T6, respectively, may be a source or a drain, and a second terminal (second electrode) may be a terminal different from the first terminal. For example, when the first terminal is a drain, the second terminal may be a source.

In an embodiment, the pixel circuit PC may be connected to a first scan line GWL that transmits a scan signal GW, an initialization gate line GIL that transmits an initialization signal GI, a reference gate line GRL that transmits a reference signal GR, a first emission control line EML that transmits a first emission control signal EM, a second emission control line EMBL that transmits a second emission control signal EMB, and a data line DL that transmits a data signal DATA. Also, the pixel circuit PC may be connected to a driving voltage line PL that transmits a driving voltage ELVDD, a first voltage line VL1 that transmits a reference voltage Vref, and a second voltage line VL2 that transmits an initialization voltage Vint.

In an embodiment, the first transistor T1 may be connected between the driving voltage line PL and a second node N2. The first transistor T1 may include a gate, the first terminal, and the second terminal connected to the second node N2. The second terminal may be a source. The gate of the first transistor T1 may include a first gate electrode Ga connected to a first node N1, and a second gate electrode Gb connected to the second node N2. The first gate electrode Ga and the second gate electrode Gb may be located on different layers and disposed to face each other. The first terminal of the first transistor T1 may be connected to the driving voltage line PL via the fifth transistor T5, and the second terminal may be connected to a pixel electrode of an organic light-emitting diode OLED. The first transistor T1 may receive the data signal DATA according to a switching operation of the second transistor T2 and may control the amount of driving current Id flowing to the organic light-emitting diode OLED.

In an embodiment, the second transistor T2 may be connected between the data line DL and the first node N1. The second transistor T2 may include a gate connected to the scan line GWL, the first terminal connected to the data line DL, and the second terminal connected to the first node N1. The second transistor T2 may be turned on by the gate signal GW transmitted through the scan line GWL, to electrically connect the data line DL to the first node N1 and transmit the data signal DATA transmitted through the data line DL to the first node N1.

In an embodiment, the third transistor T3 may be connected between the first node N1 and the first voltage line VL1. The third transistor T3 may include a gate connected to the reference gate line GRL, the first terminal connected to the first node N1, and the second terminal connected to the first voltage line VL1. The third transistor T3 may be turned on by the reference signal GR transmitted through the reference gate line GRL, to transmit the reference voltage Vref transmitted through the first voltage line VL1 to the first node N1.

In an embodiment, the fourth transistor T4 may be connected between the first transistor T1 and the second voltage line VL2. The fourth transistor T4 may include a gate connected to the initialization gate line GIL, the first terminal connected to the second terminal of the sixth transistor T6 and the organic light-emitting diode OLED, and the second terminal connected to the second voltage line VL2. The fourth transistor T4 may be turned on by the initialization signal GI transmitted through the initialization gate line GIL, to transmit the initialization voltage Vint transmitted through the second voltage line VL2 to the pixel electrode of the organic light-emitting diode OLED.

In an embodiment, the fifth transistor T5 may be connected between the driving voltage line PL and the first transistor T1. The fifth transistor T5 may include a gate connected to the first emission control line EML, the first terminal connected to the driving voltage line PL, and the second terminal connected to the first terminal of the first transistor T1. The fifth transistor T5 may be turned on or turned off according to the first emission control signal EM transmitted through the first emission control line EML.

In an embodiment, the sixth transistor T6 may be connected between the first transistor T1 and the organic light-emitting diode OLED. The sixth transistor T6 may include a gate connected to the second emission control line EMBL, the first terminal connected to the second node N2, and the second terminal connected to the organic light-emitting diode OLED. The sixth transistor T6 may be turned on by the second emission control signal EMB transmitted through the second emission control line EMBL, to connect the second node N2 to the pixel electrode of the organic light-emitting diode OLED.

In an embodiment, although the fifth transistor T5 and the sixth transistor T6 operate in response to different emission control signals i.e., EM and EMB in FIG. 3, in another embodiment, the fifth transistor T5 and the sixth transistor T6 may operate in response to the same emission control signal.

In an embodiment, the reference signal GR may be substantially synchronized with the scan signal GW of the pixel circuit PC located in a previous row. The initialization signal GI may be substantially synchronized with the scan signal GW. In another embodiment, the initialization signal GI may be substantially synchronized with the scan signal GW or the reference signal GR of the pixel circuit PC located in a next row.

In an embodiment, a storage capacitor Cst may be connected between the first node N1 and the second node N2. In other words, the pixel circuit PC included in the display apparatus according to an embodiment may be a source follower type circuit in which the storage capacitor Cst is connected between the first node N1 and the second node N2. A first storage electrode CEs1 of the storage capacitor Cst may be connected to the first node N1, and a second storage electrode CEs2 may be connected to the second node N2. The storage capacitor Cst may store a threshold voltage of the first transistor T1 and a voltage corresponding to the data signal DATA.

In an embodiment, a hold capacitor Chd may be connected between the driving voltage line PL and the second node N2. A first hold electrode CEh1 of the hold capacitor Chd may be connected to the driving voltage line PL, and a second hold electrode CEh2 may be connected to the second node N2.

In an embodiment, the organic light-emitting diode OLED may include the pixel electrode connected to the second node N2 and a counter electrode facing the pixel electrode, and the counter electrode may receive a common voltage ELVSS. The counter electrode may be a common electrode common to a plurality of pixels.

In an embodiment, although the pixel circuit PC includes six transistors and two capacitors in FIG. 3, in another embodiment, the pixel circuit PC may include five transistors and two capacitors. In still another embodiment, the pixel circuit PC may include seven transistors and two capacitors.

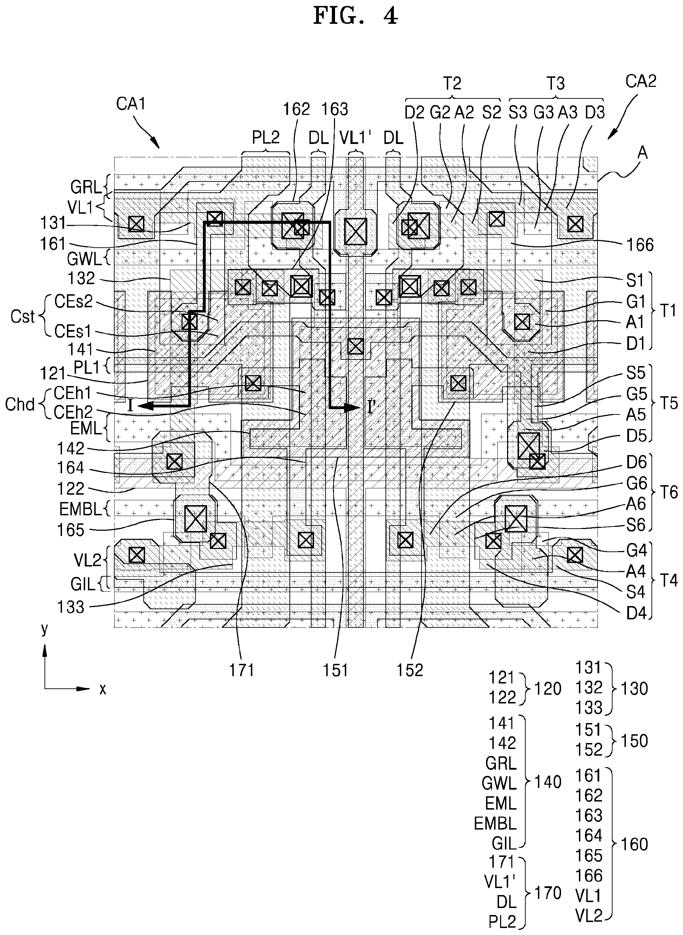

FIG. 4 is a layout view schematically illustrating a layout of an area A of the display apparatus 1 of FIG. 2, according to an embodiment.

In an embodiment, FIG. 4 illustrates a pair of pixels located in the same row of adjacent columns. A pixel circuit of a pixel located in a first pixel area CA1 of FIG. 4 and a pixel circuit of a pixel located in a second pixel area CA2 have a left-right symmetric structure. The pixel circuit located in each of the first pixel area CA1 and the second pixel area CA2 may correspond to the pixel circuit PC of FIG. 3. For convenience of explanation, only one side of the symmetric structure will be described.

In an embodiment and referring to FIG. 4, the reference gate line GRL, the scan line GWL, a first driving voltage line PL1, the first emission control line EML, the second emission control line EMBL, the initialization gate line GIL, the first voltage line VL1, and the second voltage line VL2 may extend in the x axis direction and may be spaced apart from each other in each row. The data line DL and the first voltage line VL1 may extend in the y axis direction and may be spaced apart from each other in each column. A second driving voltage line PL2 may include a portion extending in the y axis direction and located in each column and a portion shared between neighboring pixel circuits. In FIG. 4, the y axis direction may be a vertical direction in a plan view and may be directed in a direction that is parallel to a direction in which the data line DL extends. The y axis direction may be defined as a first direction for convenience of explanation. The x axis direction may be a horizontal direction in a plan view and may be directed in a direction intersecting or perpendicular to the y axis direction. The x direction may be defined as a second direction for convenience of explanation.

In an embodiment, the pixel circuit may include the first transistor T1, the second transistor T2, the third transistor T3, the fourth transistor T4, the fifth transistor T5, the sixth transistor T6, the storage capacitor Cst, and the hold capacitor Chd. In an embodiment, the pixel circuit located in the first pixel area CA1 and the pixel circuit located in the second pixel area CA2 may be electrically connected to display elements emitting light of different colors. For example, the pixel circuit of the first pixel area CA1 may be electrically connected to the light-emitting diode LED (see FIG. 3) emitting light of a first color and the pixel circuit of the second pixel area CA2 may be electrically connected to the light-emitting diode LED (see FIG. 3) emitting light of a second color.

In an embodiment, the first to sixth transistors T1, T2, T3, T4, T5, and T6, respectively, may be oxide-based thin-film transistors including an oxide semiconductor. Semiconductor layers of the first to sixth transistors T1, T2, T3, T4, T5, and T6, respectively, may be located on the same layer and may include the same material. For example, the semiconductor layer may include an oxide semiconductor. Each of the semiconductor layers of the first to sixth transistors T1, T2, T3, T4, T5, and T6, respectively, may include a channel region, a source region and a drain region on both sides of the channel region. Each source region and each drain region may respectively correspond to a source electrode and a drain electrode. The source region and the drain region may be changed from each other according to the characteristics of the transistor. Hereinafter, the terms "source region" and "drain region" are used instead of the terms "source electrode" and "drain electrode".

In an embodiment, the first transistor T1 may include a first semiconductor layer AO1 (see FIG. 6) including an oxide semiconductor and a first gate electrode G1. The first semiconductor layer AO1 may include a first channel region A1, a first source region S1 and a first drain region D1 located on both sides of the first channel region A1. The first semiconductor layer AO1 (see FIG. 6) may have a straight shape extending in the y axis direction to form a long channel in a narrow space. In some embodiments, the first semiconductor layer AO1 (see FIG. 6) may have a bent shape, rather than a straight shape. The first gate electrode G1 may have an isolated shape and may overlap the first channel region A1 with a first gate insulating layer 113 (see FIG. 6) therebetween. In an embodiment, the first gate electrode G1 may refer to the first gate electrode Ga of FIG. 3.

In an embodiment, the storage capacitor Cst may overlap the first transistor T1. The storage capacitor Cst may include the first storage electrode CEs1 and the second storage electrode CEs2. The first gate electrode G1 may function as a control electrode of the first transistor T1 and may also function as the first storage electrode CEs1 of the storage capacitor Cst. That is, the first gate electrode G1 and the first storage electrode CEs1 may be integrally formed with each other. The second storage electrode CEs2 of the storage capacitor Cst may overlap the first storage electrode CEs1 with a second gate insulating layer 114 (see FIG. 6) therebetween. In this case, the second gate insulating layer 114 (see FIG. 6) may function as a dielectric layer of the storage capacitor Cst.

In an embodiment, the second transistor T2 may include a second semiconductor layer AO2 (see FIG. 6) including an oxide semiconductor and a second gate electrode G2. The second semiconductor layer AO2 (see FIG. 6) may include a second channel region A2, a second source region S2 and a second drain region D2 located on both sides of the second channel region A2. The second drain region D2 may be electrically connected to the data line DL, and the second source region S2 may be connected to a third source region S3 of the third transistor T3. The second gate electrode G2 may be provided as a part of the scan line GWL.

In an embodiment, the third transistor T3 includes a third semiconductor layer including an oxide semiconductor and a third gate electrode G3. The third semiconductor layer includes a third channel region A3, the third source region S3 and a third drain region D3 located on both sides of the third channel region A3. The third source region S3 may be bridge-connected to the first gate electrode G1 through a node connection line 166. Also, the third source region S3 may be connected to the second source region S2 located on the same layer. The third drain region D3 may be electrically connected to the first voltage line VL1. The third gate electrode G3 may be provided as a part of the reference gate line GRL.

In an embodiment, the fourth transistor T4 includes a fourth semiconductor layer including an oxide semiconductor and a fourth gate electrode G4. The fourth semiconductor layer includes a fourth channel region A4, a fourth source region S4 and a fourth drain region D4 located on both sides of the fourth channel region A4. The fourth source region S4 may be electrically connected to the second voltage line VL2, and the fourth drain region D4 may be connected to a sixth source region S6 located on the same layer. The fourth gate electrode G4 may be provided as a part of the initialization gate line GIL.

In an embodiment, the fifth transistor T5 may include a fifth semiconductor layer and a fifth gate electrode G5. The fifth semiconductor layer may include a fifth channel region A5, a fifth source region S5 and a fifth drain region D5 located on both sides of the fifth channel region A5. The fifth source region S5 may be connected to the first drain region D1, and the fifth drain region D5 may be electrically connected to the first driving voltage line PL1. The fifth gate electrode G5 may be provided as a part of the first emission control line EML.

In an embodiment, the sixth transistor T6 may include a sixth semiconductor layer and a sixth gate electrode G6. The sixth semiconductor layer may include a sixth channel region A6, the sixth source region S6 and a sixth drain region D6 located on both sides of the sixth channel region A6. The sixth source region S6 may be formed on the same layer as the fourth drain region D4 and may be connected to the fourth drain region D4 and may be electrically connected to a pixel electrode of the light-emitting diode LED through a connection electrode. The sixth drain region D6 may be connected to the second storage electrode CEs2 through a connection electrode. The sixth gate electrode G6 may be provided as a part of the second emission control line EMBL.

In an embodiment, the hold capacitor Chd may have a structure in which the first hold electrode CEh1 and the second hold electrode CEh2 overlap each other. The first hold electrode CEh1 may be electrically connected to the first driving voltage line PL1 and may be provided on the same layer as the first storage electrode CEs1. The second hold electrode CEh2 may be connected to a first gate electrode G1 and the sixth drain electrode D6 through a connection electrode and may be provided on the same layer as the first gate electrode G1. However, each of the first hold electrode CEh1 and the second hold electrode CEh2 may have an isolated shape, and the first hold electrode CEh1 may include a portion shared between neighboring pixel circuits. In this case, the second gate insulating layer 114 (see FIG. 6) may function as a dielectric layer of the hold capacitor Chd.

In an embodiment, the display apparatus 1 may have a structure in which a lower metal layer 120, a semiconductor layer 130, a gate layer 140, a first conductive layer 150, a second conductive layer 160, and a third conductive layer 170 are sequentially stacked.

First, in an embodiment, the lower metal layer 120 may be located between the semiconductor layer 130 including an oxide semiconductor and the substrate 100 (see FIG. 2), to block external light toward the semiconductor layer 130. The external light may refer to light coming from the outside of a rear surface of the display apparatus 1 or light reaching the rear surface through a front surface and reflected from the rear surface of the display apparatus 1. The lower metal layer 120 may include molybdenum (Mo), aluminum (Al), copper (Cu), and/or titanium (Ti), and may have a single or multi-layer structure. For example, the lower metal layer 120 may have a single-layer structure including Mo.

In an embodiment, the lower metal layer 120 may include a first lower metal pattern 121 and a second lower metal pattern 122. The first lower metal pattern 121 and the second lower metal pattern 122 may be located on the same layer and may be spaced apart from each other in a plan view. The first lower metal pattern 121 may overlap the first gate electrode G1 and may have a shape corresponding to the first storage electrode CEs1 and a second semiconductor pattern 132. The second lower metal pattern 122 may have a shape corresponding to the first hold electrode CEh1 and may include a portion partially shared between the first pixel area CA1 and the second pixel area CA2. Also, the second lower metal pattern 122 may include connection wirings extending in the y axis direction and the x axis direction and may be electrically connected to neighboring pixel circuits.

In an embodiment, the semiconductor layer 130 may be located on the lower metal layer 120. The semiconductor layer 130 may include an oxide semiconductor. In detail, the semiconductor layer 130 may include an oxide of at least one material selected from the group consisting of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). For example, the semiconductor layer 130 may be an InSnZnO (ITZO) semiconductor layer or an InGaZnO (IGZO) semiconductor layer. When necessary, a conductive process by plasma treatment or the like may be performed on at least a part of the semiconductor layer 130.

In an embodiment, the semiconductor layer 130 may include a first semiconductor pattern 131, the second semiconductor pattern 132, and a third semiconductor pattern 133. The first semiconductor pattern 131, the second semiconductor pattern 132, and the third semiconductor pattern 133 may be located on the same layer and may be spaced apart from each other in a plan view. The first semiconductor pattern 131 may extend in the x axis direction and may correspond to the semiconductor layer of the second transistor T2 and the semiconductor layer of the third transistor T3. That is, the first semiconductor pattern 131 may include the second source region S2, the second channel region A2, and the second drain region D2 of the second transistor T2, and may include the third source region S3, the third channel region A3, and the third drain region D3 of the third transistor T3. The second source region S2 of the second transistor T2 and the third source region S3 of the third transistor T3 may be integrally formed and connected to each other.

In an embodiment, the second semiconductor pattern 132 may include a first portion extending in the x axis direction and a second portion extending in the y axis direction, to have a ' 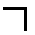 '- shape (or an inverted 'L' shape). The first portion of the second semiconductor pattern 132 may correspond to the semiconductor layer of the first transistor T1 and the semiconductor layer of the fifth transistor T5. That is, the second semiconductor pattern 132 may include the first source region S1, the first channel region A1, and the first drain region D1 of the first transistor T1, and the fifth source region S5, the fifth channel region A5, and the fifth drain region D5 of the fifth transistor T5. The first drain region D1 of the first transistor T1 and the fifth source region S5 of the fifth transistor T5 may be integrally formed and connected to each other.

In an embodiment, the third semiconductor pattern 133 may extend in the x axis direction, and may correspond to the semiconductor layer of the fourth transistor T4 and the semiconductor layer of the sixth transistor T6. That is, the third semiconductor pattern 133 may include the fourth source region S4, the fourth channel region A4, and the fourth drain region D4 of the fourth transistor T4, and may include the sixth source region S6, the sixth channel region A6, and the sixth drain region D6 of the sixth transistor T6. The fourth drain region D4 of the fourth transistor T4 and the sixth source region S6 of the sixth transistor T6 may be integrally formed and connected to each other.

In an embodiment, the gate layer 140 may be located on the semiconductor layer 130. The gate layer 140 may include molybdenum (Mo), aluminum (Al), copper (Cu), and/or titanium (Ti), and may have a single or multi-layer structure. The gate layer 140 may include the reference gate line GRL, the scan line GWL, a first gate pattern 141, a second gate pattern 142, the first emission control line EML, the second emission control line EMBL, and the initialization gate line GIL. The reference gate line GRL, the scan line GWL, the first gate pattern 141, the second gate pattern 142, the first emission control line EML, the second emission control line EMBL, and the initialization gate line GIL may be located on the same layer and may be spaced apart from each other.

In an embodiment, the reference gate line GRL, the scan line GWL, the first emission control line EML, the second emission control line EMBL, and the initialization gate line GIL may extend in the x axis direction. A portion integrally formed with the reference gate line GRL and extending in the y axis direction intersecting the x axis direction may be the third gate electrode G3 of the third transistor T3. A portion integrally formed with the scan line GWL and extending in the y axis direction intersecting the x axis direction may be the second gate electrode G2 of the second transistor T2. A portion of the first emission control line EML overlapping the second semiconductor pattern 132 may be the fifth gate electrode G5 of the fifth transistor T5. A portion integrally formed with the second emission control line EMBL and extending in the y axis direction intersecting the x axis direction may be the sixth gate electrode G6 of the sixth transistor T6. A portion integrally formed with the initialization gate line GIL and extending in the y axis direction intersecting the x axis direction may be the fourth gate electrode G4 of the fourth transistor T4.

In an embodiment, each of the first gate pattern 141 and the second gate pattern 142 may have an isolated shape. The first gate pattern 141 may overlap the first lower metal pattern 121 and a 1-1 conductive pattern 151, may have a shape similar to a quadrangular shape, and may correspond to the first gate electrode G1 and the first storage electrode CEs1. The second gate pattern 142 may overlap the second lower metal pattern 122 and a 1-2 conductive pattern 152, may have a shape similar to an 'L' shape, and may correspond to the second hold electrode CEh2.

In an embodiment, the first conductive layer 150 may be located on the gate layer 140. The first conductive layer 150 may include molybdenum (Mo), aluminum (Al), copper (Cu), and/or titanium (Ti), and may have a single or multi-layer structure. The first conductive pattern 150 may include the 1-1 conductive pattern 151 and the 1-2 conductive pattern 152. The 1-1 conductive pattern 151 and the 1-2 conductive pattern 152 may be located on the same layer and may be spaced apart from each other. The 1-1 conductive pattern 151 may overlap the first lower metal pattern 121 and the first gate pattern 141, may have a shape similar to an 'H' shape for electrical connection between different conductive layers, and may correspond to the second storage electrode CEs2. The 1-2 conductive pattern 152 may overlap the second lower metal pattern 122 and the second gate pattern 142, may include a portion shared by the first pixel area CA1 and the second pixel area CA2, and may have a shape similar to a ' 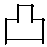 ' shape. The 1-2 conductive pattern 152 may correspond to the first hold electrode CEh1.

In an embodiment, the second conductive layer 160 may be located on the first conductive layer 150. The second conductive layer 160 may include molybdenum (Mo), aluminum (Al), copper (Cu), and/or titanium (Ti), and may have a single or multi-layer structure. The second conductive layer 160 may include the first voltage line VL1, a 2-1 conductive pattern 161, a 2-2 conductive pattern 162, a 2-3 conductive pattern 163, the first driving voltage line PL1, a 2-4 conductive pattern 164, a 2-5 conductive pattern 165, and the second voltage line VL2. The first voltage line VL1, the 2-1 conductive pattern 161, the 2-2 conductive pattern 162, the 2-3 conductive pattern 163, the first driving voltage line PL1, the 2-4 conductive pattern 164, the 2-5 conductive pattern 165, and the second voltage line VL2 may be located on the same layer and may be spaced apart from each other.

In an embodiment, the first voltage line VL1, the first driving voltage line PL1, and the second voltage line VL2 may extend in the x axis direction. The 2-1 conductive pattern 161 may extend in the y axis. One end of the 2-1 conductive pattern 161 may be connected to the first gate pattern 141 through a through-hole, and the other end of the 2-1 conductive pattern 161 may be connected to the first semiconductor pattern 131 through a through-hole. The 2-2 conductive pattern 162 may have an isolated shape, may be connected to the first semiconductor pattern 132 through a through-hole, and may be connected to the data line DL through another through-hole, to transmit the data signal DATA (see FIG. 3) to the second transistor T2. The 2-3 conductive pattern 163 may extend in the x axis direction and may be connected to other layers through a plurality of through-holes. One end of the 2-3 conductive pattern 163 may be connected to the 1-1 conductive pattern 151 through a through-hole, and the other end of the 2-3 conductive pattern 163 may be connected to the second gate pattern 142. Also, the 2-3 conductive pattern 163 may be connected to the second semiconductor pattern 132 and the first lower metal pattern 121 through central through-holes. The 2-4 conductive pattern 164 may partially overlap the hold capacitor Chd. One end of the 2-4 conductive pattern 164 may be connected to the second storage electrode CEs2 through a through-hole, and the other end of the 2-4 conductive pattern 164 may be connected to the third semiconductor pattern 133 through a through-hole. The 2-5 conductive pattern 165 may have an isolated shape, may be connected to a 3-1 conductive pattern through a through-hole, and may be connected to the third semiconductor pattern 133 through another through-hole.

In an embodiment, the third conductive layer 170 may be located on the second conductive layer 160. The third conductive layer 170 may include molybdenum (Mo), aluminum (Al), copper (Cu), and/or titanium (Ti), and may have a single or multi-layer structure. The third conductive layer 170 may include the 3-1 conductive pattern 171, a first voltage line VL1', the data line DL, and the second driving voltage line PL2. The 3-1 conductive pattern 171, the first voltage line VL1', the data line DL, and the second driving voltage line PL2 may be located on the same layer and may be spaced apart from each other. The 3-1 conductive pattern 171 may have an isolated shape, may be connected to the 2-5 conductive pattern 165 through a through-hole, and may be connected to the light-emitting diode LED (see FIG. 3) through another through-hole. The first voltage line VL1' may extend in the y axis direction, may intersect the first voltage line VL1 extending in the x axis direction, and may be electrically connected through a through-hole. The data line DL and the second driving voltage line PL2 may extend in the y axis direction.

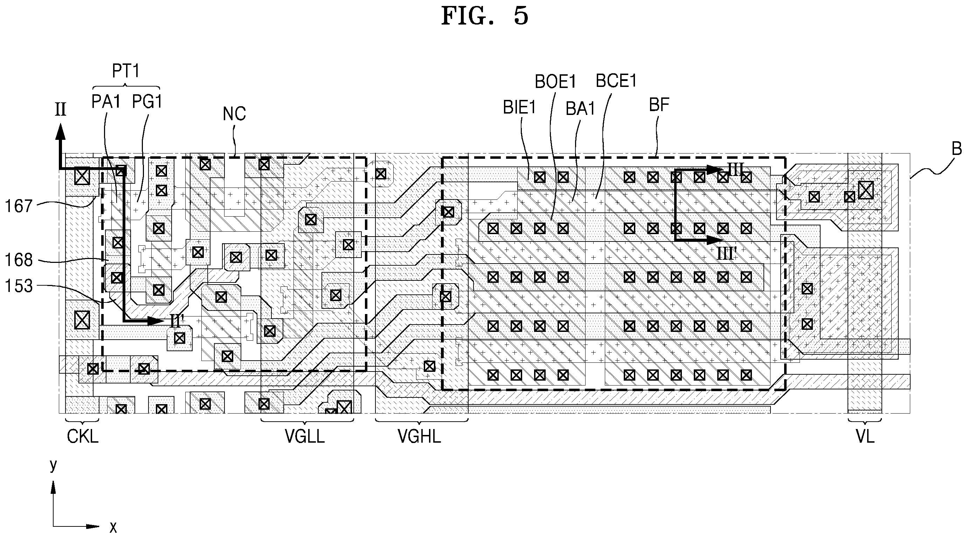

FIG. 5 is a layout view schematically illustrating a layout of an area B of the display apparatus of FIG. 2, according to an embodiment.

In an embodiment, FIG. 5 is an enlarged view illustrating a portion of the first driving circuit unit 1300 (see FIG. 2) and is a layout view schematically illustrating a layout of a driving circuit. As described above, each of the first driving circuit unit 1300 (see FIG. 2) and the second driving circuit unit 1310 (see FIG. 2) may include an emission control driving circuit, a gate driving circuit, and a scan driving circuit. In detail, the scan driving circuit may include scan stages for outputting a scan signal. The scan stages may sequentially output scan signals to pixels, based on a scan control signal. FIG. 5 may be an enlarged layout view schematically illustrating one of a plurality of scan stages of the scan driving circuit.

In an embodiment, the scan stage may include a node controller NC and a buffer transistor BF. The node controller NC may include a plurality of transistors and capacitors and may control a voltage of a node by using a start signal provided through an input terminal. The buffer transistor BF may be a transistor located to isolate a signal source from a circuit driven by the signal source.

In an embodiment, the node controller NC may include a first peripheral transistor PT1. The first peripheral transistor PT1 may include a first peripheral semiconductor layer PA1 including a silicon semiconductor and a first peripheral gate electrode PG1 insulated from the first peripheral semiconductor layer PA1. For example, the first peripheral semiconductor layer PA1 may include amorphous silicon or polysilicon. The first peripheral semiconductor layer PA1 may extend in the y axis direction and may include a channel region overlapping the first peripheral gate electrode PG1, a source region located over the channel region in a plan view and a drain region located under the channel region in a plan view. The node controller NC may further include connection electrodes 167, 168, and 153 for electrically connecting the first peripheral transistor PT1 to an input line or another transistor.

In an embodiment, the buffer transistor BF may include a buffer semiconductor layer BA1. The buffer semiconductor layer BA1 and the first peripheral semiconductor layer PA1 of the first peripheral transistor PT1 may be located on the same layer and may include the same material. For example, the buffer semiconductor layer BA1 may include a silicon semiconductor and may include amorphous silicon and/or polysilicon. Also, the buffer transistor BF may include first branch input electrodes BIE1 and first branch output electrodes BOE1 divided into branch shapes. For example, a plurality of first branch output electrodes BOE1 may extend in the x axis direction, and the plurality of first branch output electrodes BOE1 may be spaced apart from each other in the y axis direction. One first branch input electrode BIE1 may be located between the first branch output electrodes BOE1 spaced apart from each other. The plurality of first branch output electrodes BOE1 and the plurality of first branch input electrodes BIE1 may be electrically connected to the buffer semiconductor layer BA1 through a plurality of contact holes. The buffer transistor BF may further include a plurality of first branch control electrodes BCE1. Like the first branch input electrodes BIE1, the plurality of first branch control electrodes BCE1 may extend in the x axis direction and may be spaced apart from each other in the y axis direction. Each of the first branch control electrodes BCE1 may be located between one first branch input electrode BIE1 and one first branch output electrode BOE1 facing each other.

In an embodiment, in the peripheral area PA (see FIG.1), a plurality of input lines for transmitting an electrical signal, in addition to a plurality of driving circuits, may be located. The plurality of input lines may include clock wirings CKL, a gate high voltage wiring VGHL, a gate low voltage wiring VGLL, and a voltage line VL. The clock wirings CKL may be signal lines for transmitting a clock signal to the scan driving circuit, and each of the clock wirings CKL may provide a first clock signal and/or a second clock signal which is a square wave signal repeating a logic high level and a logic low level. The gate high voltage wiring VGHL and the gate low voltage wiring VGLL may be wirings for applying a driving voltage to the scan driving circuit. For example, the gate high voltage wiring VGHL may be a wiring to which a gate-off voltage is applied, and the gate low voltage wiring VGHLL may be a wiring to which a gate-on voltage is applied. The voltage line VL may be a voltage wiring for transmitting a voltage to each of pixel circuits. For example, the voltage line VL may be the second voltage line VL2 that transmits the initialization voltage Vint (see FIG. 3) to each of the pixel circuits. The plurality of input lines may overlap or be located adjacent to the plurality of driving circuits. For example, the clock wirings CKL, the gate high voltage wiring VGHL, the gate low voltage wiring VGLL, and the voltage lines VL may be located on the plurality of driving circuits.

FIG. 6 is a cross-sectional view schematically illustrating parts of a display apparatus, according to an embodiment. FIG. 6 is a schematic cross-sectional view taken along line I-I' of FIG. 4, taken along line II-II' of FIG. 5, and taken along line III-III' of FIG. 5. FIG. 6 is a cross-sectional view illustrating portions corresponding to the first transistor T1, the second transistor T2, the storage capacitor Cst, the hold capacitor Chd, and the organic light-emitting diode OLED of FIG. 4, wherein some members are not shown.

In an embodiment, the substrate 100 may include a glass material, a ceramic material, a metal material, and/or a flexible and/or bendable material. When the substrate 100 is flexible and/or bendable, the substrate 100 may include a polymer resin such as polyethersulfone (PES), polyacrylate, polyetherimide (PEI), polyethylene naphthalate (PEN), polyethylene terephthalate (PET), polyphenylene sulfide (PPS), polyarylate, polyimide (PI), polycarbonate (PC), and/or cellulose acetate propionate (CAP).

In an embodiment, the substrate 100 may have a single or multi-layer structure including the above material, and when the substrate 100 has a multi-layer structure, the substrate 100 may further include an inorganic layer. For example, the substrate 100 may have a stacked structure including a first base layer, a barrier layer, and a second base layer. Each of the first base layer and the second base layer may be an organic layer including a polymer resin. Each of the first base layer and the second base layer may include a transparent polymer resin. The barrier layer for preventing penetration of an external foreign material may have a single or multi-layer structure including an inorganic material such as silicon nitride (SiNx) and/or silicon oxide (SiOx).

In an embodiment, a buffer layer 111 may be located on the substrate 100. The buffer layer 111 may planarize a top surface of the substrate 100 and may include an oxide film such as silicon oxide (SiOx), and/or a nitride film such as silicon nitride (SiNx), or silicon oxynitride (SiON).

In an embodiment, barrier layers (e.g., 110a and 110b) may be further provided between the substrate 100 and the buffer layer 111. The barrier layers (e.g., 110a and 110b) may prevent or minimize penetration of impurities from the substrate 100 or the like into a silicon semiconductor layer. The barrier layers (e.g., 110a and 110b) may have single or multi-layer structure including an inorganic material such as silicon nitride (SiNx) and/or silicon oxide (SiOx). The barrier layers (e.g., 110a and 110b) may include a first barrier layer 110a and a second barrier layer 110b.

In an embodiment, as shown in FIG. 6, the lower metal layer 120 (see FIG. 4) may be located between the first barrier layer 110a and the second barrier layer 110b. The lower metal layer 120 (see FIG. 4) may include the first lower metal pattern 121 (see FIG. 4) located to correspond to the first transistor T1 and the second lower metal pattern 122 (see FIG. 4) located to correspond to the hold capacitor Chd. In another embodiment, the lower metal layer 120 (see FIG. 4) may be located between the second barrier layer 110b and the buffer layer 111.

In an embodiment and as shown in FIG. 6, the first peripheral semiconductor layer PA1 of the first peripheral transistor PT1 (see FIG. 5) and the buffer semiconductor layer BA1 of the buffer transistor BF (see FIG. 5) may be located on the buffer layer 111. As described above, the first peripheral semiconductor layer PA1 and the buffer semiconductor layer BA1 may be located on the same layer and may include a silicon semiconductor.

In an embodiment, an insulating layer 112 may be located to cover the first peripheral semiconductor layer PA1 and the buffer semiconductor layer BA1. The insulating layer 112 may include an inorganic material including oxide and/or nitride. For example, the insulating layer 112 may include at least one of silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), and zinc oxide (ZnO₂).

In an embodiment, the first semiconductor layer AO1 of the first transistor T1 and the second semiconductor layer AO2 of the second transistor T2 may be located on the insulating layer 112. Each of the first semiconductor layer AO1 and the second semiconductor layer AO2 may include an oxide semiconductor as described above.

In an embodiment, as shown in FIG. 6, the insulating layer 112 may be located between the first semiconductor layer AO1 and the first peripheral semiconductor layer PA1. That is, the first and second semiconductor layers AO1 and AO2 located in the pixel circuit PC (see FIG. 2) and including an oxide semiconductor may be located on the semiconductor layers PA1 and BA1 located in a driving circuit and including a silicon semiconductor. In other words, the insulating layer 112 may be located on a silicon-based semiconductor layer located in the peripheral area PA (see FIG. 2), and an oxide-based semiconductor layer located in the display area DA (see FIG. 2) may be located on the insulating layer 112.

In an embodiment, the first gate insulating layer 113 may be located on the first semiconductor layer AO1 and the second semiconductor layer AO2. The first gate insulating layer 113 may include an inorganic material including oxide and/or nitride. For example, the first gate insulating layer 113 may include at least one of silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), and zinc oxide (ZnO₂).

In an embodiment, the first gate electrode G1, the second gate electrode G2, the scan line GWL, the second hold electrode CEh2, the first peripheral gate electrode PG1, and the first branch control electrode BCE1 may be located on the first gate insulating layer 113. The first gate electrode G1 may be integrally formed with the first storage electrode CEs1. That is, the first gate electrode G1 may function as a control electrode of the first transistor T1 and may also function as the first storage electrode CEs1 of the storage capacitor Cst.

In an embodiment, the first gate electrode G1, the second gate electrode G2, the scan line GWL, the second hold electrode CEh2, the first peripheral gate electrode PG1, and the first control electrode BCE1 may be located on substantially the same layer and may include the same material. For example, each of the first gate electrode G1, the second gate electrode G2, the scan line GWL, the second hold electrode CEh2, the first peripheral gate electrode PG1, and the first control electrode BCE1 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu), and may have a single or multi-layer structure including at least one material.

In other words, in an embodiment, a plurality of transistors (e.g., T1 and T2) located in the display area DA (see FIG. 2) and a plurality of peripheral transistors (e.g., PT1 and BF) (see FIG. 5) located in the peripheral area PA (see FIG. 2) respectively include an oxide-based semiconductor and a silicon-based semiconductor, and although semiconductor layers are located on different layers, gate electrodes of the plurality of transistors and the plurality of peripheral transistors may be located on the same layer. According to an embodiment of the display apparatus 1, the number of masks required in a forming process may be reduced and a process step may be simplified, thereby reducing costs. In detail, compared to a structure in which both an oxide-based transistor and a silicon-based transistor are used but gate electrodes are located on different layers, the number of masks required for an additional gate layer may be reduced by 1 and a process step of forming an additional gate electrode may be excluded, thereby greatly reducing costs. In addition, because a process step of forming an additional gate electrode is removed, defects which may occur in the process may be prevented, thereby reducing a defect rate in a process of forming a display apparatus.

In an embodiment, the insulating layer 112 and the first gate insulating layer 113 may be located between the first peripheral semiconductor layer PA1 and the first peripheral gate electrode PG1, and only the first gate insulating layer 113 may be located between the first semiconductor layer AO1 and the first gate electrode G1. That is, in the plurality of transistors (e.g., PT1 and BF) (see FIG. 5) located in a driving circuit, two insulating layers may be located between a semiconductor layer and a gate electrode, and in the plurality of transistors (e.g., T1 and T2) located in a pixel circuit, only one insulating layer may be located between a semiconductor layer and a gate electrode.

In an embodiment, as shown in FIG. 6, in an oxide-based transistor such as the first transistor T1, when one insulating layer is located between the first semiconductor layer AO1 and the first gate electrode G1, the first transistor T1 that is a driving transistor may have excellent electrical characteristics. In contrast, in a silicon-based transistor such as the first peripheral transistor PT1, even when two insulating layers are located between the first peripheral semiconductor layer PA1 and the first peripheral gate electrode PG1, electrical characteristics of the silicon-based transistor may not be adversely affected. Also, because the insulating layer 112 is formed during a process of forming the first semiconductor layer AO1 after the first peripheral semiconductor layer PA1 is formed, a silicon-based semiconductor layer such as the first peripheral semiconductor layer PA1 and the buffer semiconductor layer BA1 may be protected. As a result, according to the display apparatus 1 of an embodiment, high-quality pixel characteristics may be ensured, a defect rate may be reduced, and thus, a high-quality image may be provided.

In an embodiment, the second gate insulating layer 114 may be located on the gate electrodes. The second gate insulating layer 114 may include an inorganic material including oxide and/or nitride. For example, the second gate insulating layer 114 may include at least one of silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), and zinc oxide (ZnO₂).

In an embodiment and as shown in FIG. 6, the connection electrode 153, the second storage electrode CEs2, and the first hold electrode CEh1 may be located on the second gate insulating layer 114. In this case, the second storage electrode CEs2 may overlap the first storage electrode CEs1, to form the storage capacitor Cst. Likewise, the first hold electrode CEh1 may overlap the second hold electrode CEh2, to form the hold capacitor Chd. That is, the second gate insulating layer 114 may function as a dielectric layer of the storage capacitor Cst and the hold capacitor Chd.

In an embodiment, the second storage electrode CEs2, the first hold electrode CEh1, and the connection electrode 153 may be located on the same layer and may include the same material. Each of the second storage electrode CEs2 and the first hold electrode CEh1 may have a single or multi-layer structure including at least one material selected from among aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu).

In an embodiment, a first interlayer insulating layer 115 may be located on the second storage electrode CEs2, the first hold electrode CEh1, and the connection electrode 153. The first interlayer insulating layer 115 may include an inorganic material including oxide and/or nitride. For example, the first interlayer insulating layer 115 may include at least one of silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), and zinc oxide (ZnO₂).

In an embodiment, the 2-1 conductive pattern 161, the 2-2 conductive pattern 162, the 2-4 conductive pattern 164, and the first driving voltage line PL1 may be located on the first interlayer insulating layer 115. The 2-1 conductive pattern 161 that is a node connection line may include one end connected to the first storage electrode CEs1 through a contact hole and the other end connected to the second semiconductor layer AO2. The 2-2 conductive pattern 162 may be connected to the second gate electrode G2 through a contact hole, to transmit a data signal received through the data line DL. The 2-3 conductive pattern 163 may be connected to the second hold electrode CEh2 through a contact hole.

In an embodiment, each of the 2-1 conductive pattern 161, the 2-2 conductive pattern 162, the 2-4 conductive pattern 164, and the first driving voltage line PL1 may be formed of a material having high conductivity such as a metal and/or a conductive oxide. For example, each of the 2-1 conductive pattern 161, the 2-2 conductive pattern 162, the 2-4 conductive pattern 164, and the first driving voltage line PL1 may have a single or multi-layer structure including at least one of aluminum (Al), copper (Cu), and titanium (Ti). In some embodiments, the second conductive layer 160 (see FIG. 4) may have a three-layer structure in which titanium, aluminum, and titanium (Ti/Al/Ti) are sequentially located. In the peripheral area PA (see FIG. 2), the connection electrodes 167 and 168, the first branch input electrode BIE1, and the first branch output electrode BOE1 located on the first interlayer insulating layer 115 may be located on the same layer as the second conductive layer 160 (see FIG. 4) and may include the same material.

In an embodiment, a first planarization layer 116 may be located on the second conductive layer 160 (see FIG. 4), and the third conductive layer 170 (see FIG. 4) may be located on the first planarization layer 116. As described with reference to FIG. 4, the third conductive layer 170 (see FIG. 4) may include the data line DL and the second driving voltage line PL2. A plurality of input lines located in the peripheral area PA (see FIG. 2), for example, the clock wiring CKL, may also be located on the same layer as the data line DL and the second driving voltage line PL 2 and may include the same material. For example, each of the data line DL, the second driving voltage line PL2, and the clock wiring CKL may have a single or multi-layer structure including at least one of aluminum (Al), copper (Cu), and titanium (Ti).

In an embodiment, a second planarization layer 117 may be located on the data line DL, the second driving voltage line PL2, and the clock wiring CKL. Each of the first planarization layer 116 and the second planarization layer 117 may include an organic material such as acryl, benzocyclobutene (BCB), polyimide, and/or hexamethyldisiloxane (HMDSO). Alternatively, each of the first planarization layer 116 and the second planarization layer 117 may include an inorganic material. Each of the first planarization layer 116 and the second planarization layer 117 may function as a protective film covering a plurality of transistors and a plurality of peripheral transistors and are provided to have a flat top surface. Each of the first planarization layer 116 and the second planarization layer 117 may have a single or multi-layer structure.

In an embodiment, a bank layer 118 may be located on the second planarization layer 117. The bank layer 118 may define a pixel by having an opening corresponding to each pixel, that is, an opening through which a part of a pixel electrode 310 is exposed. Also, the bank layer 118 increases a distance between an edge of the pixel electrode 310 and a counter electrode 330 over the pixel electrode 310 to prevent an arc or the like from occurring at the edge of the pixel electrode 310. The bank layer 118 may be formed of an organic material such as polyimide and/or hexamethyldisiloxane (HMDSO).

In an embodiment, an intermediate layer 320 of the organic light-emitting diode OLED may include a low molecular weight material or a high molecular weight material. When the intermediate layer 320 includes a low molecular weight material, the intermediate layer 320 may have a structure in which a hole injection layer (HIL), a hole transport layer (HTL), an emission layer, an electron transport layer (ETL), and an electron injection layer (EIL) are stacked in a single or composite structure, and may include any of various organic materials such as copper phthalocyanine (CuPc), N,N'-Di(naphthalene-1-yl)-N,N'-diphenyl-benzidine (NPB), or tris-8-hydroxyquinoline aluminum (Alq3). These layers may be formed by using vacuum deposition.

In an embodiment, when the intermediate layer 320 includes a high molecular weight material, the intermediate layer 320 may have a structure including an HTL and an emission layer. In this case, the HTL may include poly(3,4-ethylenedioxythiophene) (PEDOT), and the emission layer may include a polymer material such as a polyphenylene vinylene (PPV)-based material or a polyfluorene-based material. The intermediate layer 320 is not necessarily limited thereto and may have any of various structures. The intermediate layer 320 may include a layer that is integrally formed over a plurality of pixel electrodes 310 and/or may include a layer that is patterned to correspond to each of the plurality of pixel electrodes 310.

In an embodiment, the counter electrode 330 may be integrally formed with a plurality of organic light-emitting diodes to correspond to the plurality of pixel electrodes 310.

In an embodiment, because the organic light-emitting diodes OLED may be easily damaged by external moisture or oxygen, a thin-film encapsulation layer (not shown) or a sealing substrate (not shown) may be located on the organic light-emitting diodes OLED to cover and protect the organic light-emitting diodes OLED. The thin-film encapsulation layer may cover the display area DA (see FIG. 2) and may extend to the outside of the display area DA (see FIG. 2). The thin-film encapsulation layer may include an inorganic encapsulation layer including at least one inorganic material and an organic encapsulation layer including at least one organic material. In some embodiments, the thin-film encapsulation layer may have a structure in which a first inorganic encapsulation layer, an organic encapsulation layer, and a second inorganic encapsulation layer are stacked. The sealing substrate (not shown) may face the substrate 100 and may be adhered to the substrate 100 in the peripheral area PA (see FIG. 2) by using a sealing member such as a sealant or a frit.

Also, in an embodiment, a spacer for preventing mask damage may be further provided on the bank layer 118, and various functional layers such as a polarization layer, a black matrix, a color filter, and/or a touchscreen layer including a touch electrode may be provided on the thin-film encapsulation layer.

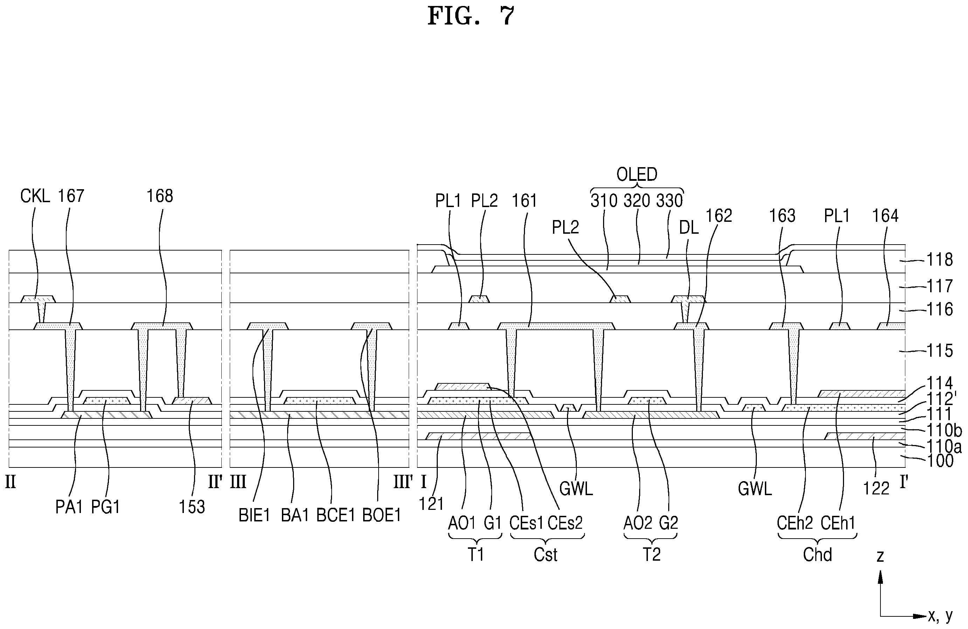

FIG. 7 is a cross-sectional view schematically illustrating parts of a display apparatus 1, according to another embodiment. Referring to FIG. 7, characteristics other than characteristics of semiconductor layers (e.g., AO1, AO2, PA1, and BA1) and a first gate insulating layer 112' are the same as those described with reference to FIGS. 4 to 6. In FIG. 7 and FIGS. 4 to 6, the same elements are denoted by the same reference numerals and a repeated explanation thereof will not be given, and the following will focus on a difference.

In an embodiment and referring to FIG. 7, not only the first peripheral semiconductor layer PA1 of the first peripheral transistor PT1 (see FIG. 5) and the buffer semiconductor layer BA1 of the buffer transistor BF (see FIG. 5) but also the first semiconductor layer AO1 of the first transistor T1 and the second semiconductor layer AO2 of the second transistor T2 may be located on the buffer layer 111. That is, although the first semiconductor layer AO1 and the second semiconductor layer AO2 including an oxide semiconductor and the first peripheral semiconductor layer PA1 and the buffer semiconductor layer BA1 including a silicon semiconductor include different materials, the first semiconductor layer AO1 and the second semiconductor layer AO2 and the first peripheral semiconductor layer PA1 and the buffer semiconductor layer BA1 may be located on substantially the same layer.

In an embodiment, the first gate insulating layer 112' may be located on the first peripheral semiconductor layer PA1, the buffer semiconductor layer BA1, the first semiconductor layer AO1, and the second semiconductor layer AO2. The first gate insulating layer 112' may include the same material as the first gate insulating layer 113 of FIG. 6, For example, the first gate insulating layer 112' may include at least one of silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), and zinc oxide (ZnO₂).

In an embodiment, the first gate electrode G1, the second gate electrode G2, the scan line GWL, the second hold electrode CEh2, the first peripheral gate electrode PG1, and the first branch control electrode BCE1 may be located on the first gate insulating layer 112'. The first gate electrode G1, the second gate electrode G2, the scan line GWL, the second hold electrode CEh2, the first peripheral gate electrode PG1, and the first branch control electrode BCE1 may be located on substantially the same layer and may include the same material.

That is, in an embodiment, only the first gate insulating layer 112' may be located between the first peripheral semiconductor layer PA1 and the first peripheral gate electrode PG1, and only the first gate insulating layer 112' may be located between the first semiconductor layer AO1 and the first gate electrode G1. When one insulating layer is located between the first semiconductor layer AO1 and the first gate electrode G1 as shown in FIG. 7, the first transistor T1 that is a driving transistor may have excellent electrical characteristics. Also, in the display apparatus 1 of FIG. 7, because the insulating layer 112 (see FIG. 6) that may be located between the first peripheral semiconductor layer PA1 and the first semiconductor layer AO1 is not located, a step of forming an insulating layer may be removed, thereby simplifying a process and reducing costs.

Also, in an embodiment and as described with reference to FIG. 6, because gate electrodes located in the display area DA (see FIG. 2) and gate electrodes located in the peripheral area PA (see FIG. 2) are located on the same layer, the number of masks required for an additional gate layer may be reduced by 1, and a process step of forming an additional gate electrode may be excluded. Accordingly, according to the display apparatus 1 of another embodiment as shown in FIG. 7, excellent electrical characteristics may be ensured and costs may be more dramatically reduced.

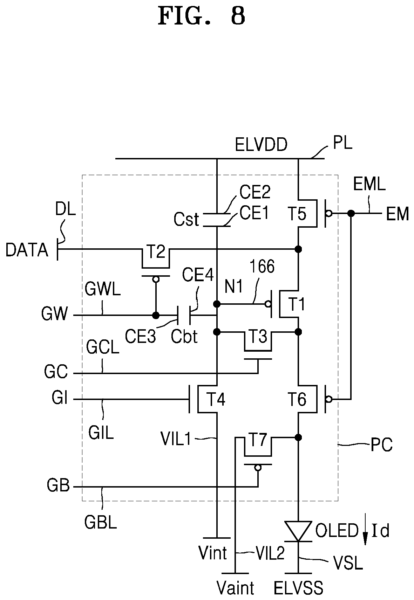

FIG. 8 is an equivalent circuit diagram schematically illustrating an organic light-emitting diode located in a display area of a display apparatus and a pixel circuit electrically connected to the organic light-emitting diode, according to another embodiment.

In an embodiment and referring to FIG. 8, an organic light-emitting diode OLED may be electrically connected to a pixel circuit PC, and the pixel circuit PC may include seven transistors and two capacitors. The pixel circuit PC may include first to seventh transistors T1, T2, T3, T4, T5, T6, and T7, respectively, a storage capacitor Cst, and a boost capacitor Cbt. In another embodiment, the pixel circuit PC may not include the boost capacitor Cbt.

In an embodiment, a pixel electrode (e.g., an anode) of the organic light-emitting diode OLED may be electrically connected to the first transistor T1 via the sixth transistor T6, and a counter electrode (e.g., a cathode) may be electrically connected to a common voltage line VSL and may receive a voltage corresponding to a common voltage ELVSS through the common voltage line VSL.

In an embodiment, some of the first to seventh transistors T1 to T7, respectively, may be n-channel MOSFETs (NMOSs) and the rest may be p-channel MOSFETs (PMOSs). In an embodiment, as shown in FIG. 7, the third and fourth transistors T3 and T4, respectively, may be NMOSs and the rest may be PMOSs. For example, the third and fourth transistors T3 and T4, respectively, may be NMOSs including an oxide-based semiconductor material, and the rest may be PMOSs including a silicon-based semiconductor material. In another embodiment, the third, fourth, and seventh transistors T3, T4, and T7, respectively, may be NMOSs, and the rest may be PMOSs.

In an embodiment, the first to seventh transistors T1, T2, T3, T4, T5, T6, and T7, respectively, the storage capacitor Cst, and the boost capacitor Cbt may be connected to signal lines. The signal lines may include a scan line GWL that transmits a scan signal GW, an emission control line EML that transmits an emission control signal EM to the fifth transistor T5 and the sixth transistor T6, a compensation gate line GCL that transmits a compensation signal GC, an initialization gate line GIL that transmits an initialization signal GI to the fourth transistor T4, a next scan line GBL that transmits a next scan signal GB to the seventh transistor T7, and a data line DL that transmits a data signal DATA. The pixel circuit PC may be electrically connected to voltage lines, for example, a driving voltage line PL, a first initialization voltage wiring VIL1, and a second initialization voltage wiring VIL2. The driving voltage line PL may transmit a driving voltage ELVDD to the first transistor T1, and the first initialization voltage wiring VIL1 and the second initialization voltage wiring VIL2 may respectively transmit initialization voltages Vint and Vaint for initializing the first transistor T1 and the anode.

In an embodiment, the first transistor T1 may be a driving transistor. A first gate electrode of the first transistor T1 may be connected to the storage capacitor Cst, a first electrode of the first transistor T1 may be electrically connected to the driving voltage line PL via the fifth transistor T5, and a second electrode of the first transistor T1 may be electrically connected to a first electrode (e.g., an anode) of the light-emitting diode OLED via the sixth transistor T6. One of the first electrode and the second electrode of the first transistor T1 may be a source electrode and the other may be a drain electrode. The first transistor T1 may supply driving current I_{d} to the organic light-emitting diode OLED according to a switching operation of the second transistor T2.

In an embodiment, the second transistor T2 may be a switching transistor. A second gate electrode of the second transistor T2 is connected to the scan line GWL, a first electrode of the second transistor T2 is connected to the data line DL, and a second electrode of the second transistor T2 is connected to the driving first electrode of the first transistor T1 and electrically connected to the driving voltage line PL via the fifth transistor T5. One of the first electrode and the second electrode of the second transistor T2 may be a source electrode and the other may be a drain electrode. The second transistor T2 may be turned on according to the scan signal GW received through the scan line GWL and may perform a switching operation of transmitting the data signal DATA received through the data line DL to the first electrode of the first transistor T1.

In an embodiment, the third transistor T3 may be a compensation transistor for compensating for a threshold voltage of the first transistor T1. A third gate electrode of the third transistor T3 is connected to the compensation gate line GCL. A first electrode of the third transistor T3 is connected to a first storage electrode CE1 of the storage capacitor Cst and the first gate electrode of the first transistor T1 through the node connection line 166. The first electrode of the third transistor T3 may be connected to the fourth transistor T4. A second electrode of the third transistor T3 is connected to the second electrode of the first transistor T1 and is electrically connected to the first electrode (e.g., the anode) of the organic light-emitting diode OLED via the sixth transistor T6. One of the first electrode and the second electrode of the third transistor T3 may be a source electrode and the other may be a drain electrode. The third transistor T3 is turned on according to the compensation signal GC received through the compensation gate line GCL to diode-connect the first transistor T1 by electrically connecting the first gate electrode and the second electrode (e.g., drain electrode) of the first transistor T1.

In an embodiment, the fourth transistor T4 may be a first initialization transistor for initializing the first gate electrode of the first transistor T1. A fourth gate electrode of the fourth transistor T4 is connected to the initialization gate line GIL. A first electrode of the fourth transistor T4 is connected to the first initialization voltage wiring VIL1. A second electrode of the fourth transistor T4 may be connected to the first storage electrode CE1 of the storage capacitor Cst, the first electrode of the third transistor T3, and the first gate electrode of the first transistor T1. One of the first electrode and the second electrode of the fourth transistor T4 may be a source electrode and the other may be a drain electrode. The fourth transistor T4 may be turned on according to the initialization signal GI received through the initialization gate line GIL and may perform an initialization operation of initializing a voltage of the first gate electrode of the first transistor T1 by transmitting a first initialization voltage Vint to the first gate electrode of the first transistor T1.

In an embodiment, the fifth transistor T5 may be an operation control transistor. A fifth gate electrode of the fifth transistor T5 is connected to the emission control line EML, a first electrode of the fifth transistor T5 is connected to the driving voltage line PL, and a second electrode of the fifth transistor T5 is connected to the first electrode of the first transistor T1 and the second electrode of the second transistor T2. One of the first electrode and the second electrode of the fifth transistor T5 may be a source electrode and the other may be a drain electrode.

In an embodiment, the sixth transistor T6 may be an emission control transistor. A sixth gate electrode of the sixth transistor T6 is connected to the emission control line EML, a first electrode of the sixth transistor T6 is connected to the second electrode of the first transistor T1 and the second electrode of the third transistor T3, and a second electrode of the sixth transistor T6 is electrically connected to a second electrode of the seventh transistor T7 and the first electrode (e.g., the anode) of the organic light-emitting diode OLED. One of the first electrode and the second electrode of the sixth transistor T6 may be a source electrode and the other may be a drain electrode.

In an embodiment, the fifth transistor T5 and the sixth transistor T6 may be simultaneously turned on according to the emission control signal EM received through the emission control line EML so that the driving voltage ELVDD is transmitted to the organic light-emitting diode OLED and the driving current I_{d} flows through the organic light-emitting diode OLED.

In an embodiment, the seventh transistor T7 may be a second initialization transistor for initializing the first electrode (e.g., the anode) of the organic light-emitting diode OLED. A seventh gate electrode of the seventh transistor T7 is connected to the next scan line GBL. A first electrode of the seventh transistor T7 is connected to the second initialization voltage wiring VIL2. The second electrode of the seventh transistor T7 is connected to the second electrode of the sixth transistor T6 and the first electrode (e.g., the anode) of the organic light-emitting diode OLED. The seventh transistor T7 may be turned on according to the next scan signal GB received through the next scan line GBL to initialize the first electrode of the organic light-emitting diode OLED by transmitting a second initialization voltage Vaint to the first electrode (e.g., the anode) of the organic light-emitting diode OLED.

In an embodiment, the next scan signal GB may be substantially synchronized with the scan signal GW. According to another embodiment, the next scan signal GB may be substantially synchronized with the scan signal GW of a next row. For example, the next scan line GBL may be substantially the same as the scan line GWL of a next row. Pixels adjacent to each other in a column direction may share the scan line GWL.

In an embodiment, the storage capacitor Cst includes the first storage electrode CE1 and a second storage electrode CE2. The first storage electrode CE1 of the storage capacitor Cst is connected to the first gate electrode of the first transistor T1, and the second storage electrode CE2 of the storage capacitor Cst is connected to the driving voltage line PL. The storage capacitor Cst may store a charge corresponding to a difference between a voltage of the first gate electrode of the first transistor T1 and the driving voltage ELVDD.

In an embodiment, the boost capacitor Cbt includes a first boost electrode CE3 and a second boost electrode CE4. The first boost electrode CE3 may be connected to the second gate electrode of the second transistor T2 and the scan line GWL, and the second boost electrode CE4 may be connected to the first electrode of the third transistor T3 and the node connection line 166. The boost capacitor Cbt may increase a voltage of a first node N1 when the scan signal GW supplied through the scan line GWL is turned off, and when a voltage of the first node N1 is increased, a black gray scale may be clearly exhibited. The first node N1 may be an area where the first gate electrode of the first transistor T1, the first electrode of the third transistor T3, the second electrode of the fourth transistor T4, and the second electrode CE4 of the boost capacitor Cbt are connected.

In an embodiment, in FIG. 8, the third and fourth transistors T3 and T4, respectively, are NMOSs, and the first, second, and fifth to seventh transistors T1, T2, T5, T6, and T7, respectively, are PMOSs. Because the first transistor T1 that directly affects the brightness of a display apparatus for displaying an image may include a semiconductor layer formed of polycrystalline silicon having high reliability, a high-resolution display apparatus may be realized.

In an embodiment, although some transistors are NMOSFETs and the rest are PMOSFETs in FIG. 8, the invention is not limited thereto. Various modifications may be made. For example, the pixel circuit PC may include three transistors, and all of the three transistors may be NMOSFETs.

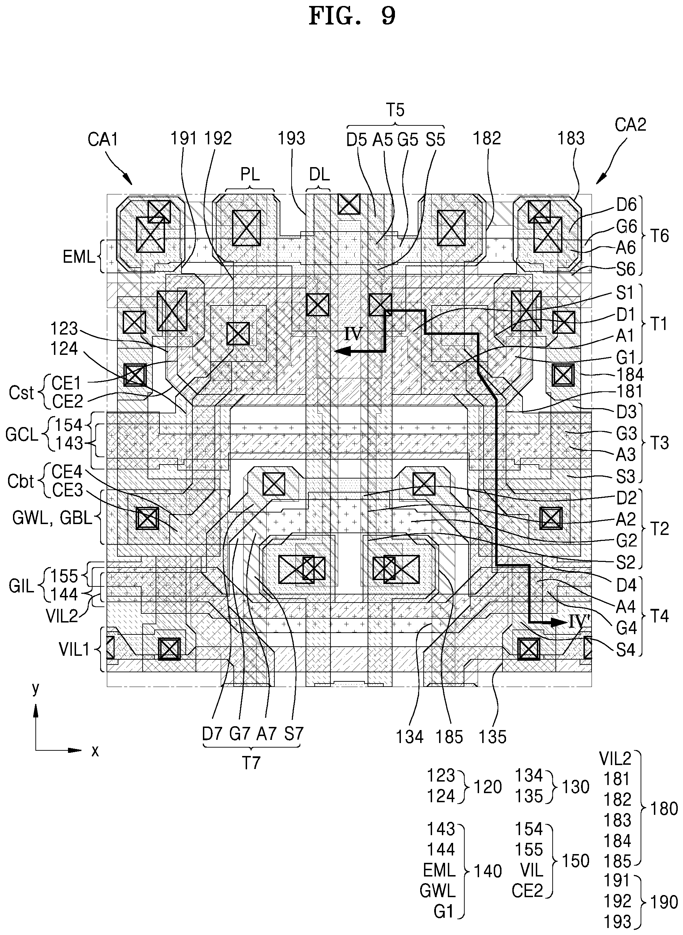

FIG. 9 is a layout view schematically illustrating a layout of a part of a display area of a display apparatus 1, according to another embodiment.

In an embodiment, FIG. 9 illustrates a pair of pixels located in the same row of an adjacent column. A pixel circuit of a pixel located in a first pixel area CA1 of FIG. 9 and a pixel circuit of a pixel located in a second pixel area CA2 have a left-right symmetric structure. The pixel circuit located in each of the first pixel area CA1 and the second pixel area CA2 may correspond to the pixel circuit PC of FIG. 3. For convenience of explanation, only one side of the symmetric structure will be described.

In an embodiment and referring to FIG. 9, the emission control line EML, the compensation gate line GCL, the scan line GWL, the initialization gate line GIL, the first initialization voltage wiring VIL1, and the second initialization voltage wiring VIL2 may extend in the x axis direction and may be spaced apart from each other in each row. The data line DL may extend in the y direction and may be spaced apart from each other in each column. The driving voltage line PL may include a portion extending in the y direction and located in each column and a portion shared between neighboring pixel circuits.

In an embodiment, the pixel circuit may include the first transistor T1, the second transistor T2, the third transistor T3, the fourth transistor T4, the fifth transistor T5, the sixth transistor T6, the seventh transistor T7, the storage capacitor Cst, and the hold capacitor Chd.

In an embodiment, each of the first transistor T1, the second transistor T2, the fifth transistor T5, the sixth transistor T6, and the seventh transistor T7 may be a silicon-based thin-film transistor including a silicon semiconductor. Each of the third transistor T3 and the fourth transistor T4 may be an oxide-based thin-film transistor including an oxide semiconductor.

In an embodiment, semiconductor layers of the first transistor T1, the second transistor T2, the fifth transistor T5, the sixth transistor T6, and the seventh transistor T7 are located on the same layer and include the same material. For example, the semiconductor layer may be formed of polycrystalline silicon. The semiconductor layers of the first transistor T1, the second transistor T2, the fifth transistor T5, the sixth transistor T6, and the seventh transistor T7 may be connected to each other and bent into any of various shapes.

In an embodiment, each of the semiconductor layers of the first transistor T1, the second transistor T2, the fifth transistor T5, the sixth transistor T6, and the seventh transistor T7 may include a channel region, a source region and a drain region on both sides of the channel region. For example, the source region and the drain region may be doped with impurities, and the impurities may include N-type impurities or P-type impurities. Each source region and each drain region may respectively correspond to a source electrode and a drain electrode. The source region and the drain region may be changed from each other according to the characteristics of the transistor. Hereinafter, the terms "source region" and "drain region" are used instead of the terms "source electrode" and "drain electrode".

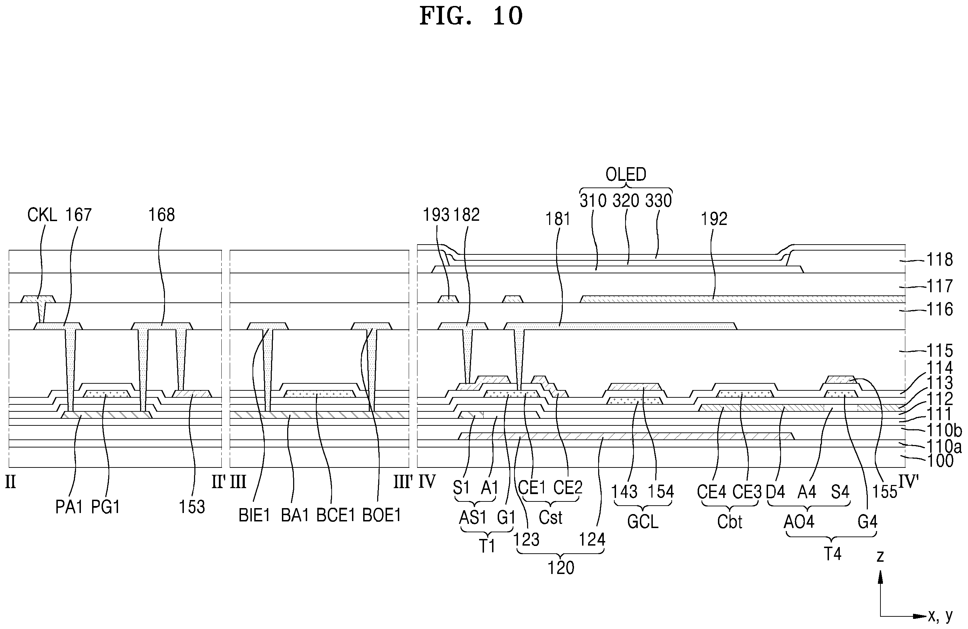

In an embodiment, the first transistor T1 may include a first semiconductor layer AS1 (see FIG. 10) and a first gate electrode G1. The first semiconductor layer AS1 (see FIG. 10) may include a first channel region A1, a first source region S1 and a first drain region D12 on both sides of the first channel region A1. The first semiconductor layer AS1 (see FIG. 10) may have a bent shape so that the first channel region A1 is longer than the other channel regions (A2 to A7). For example, because the first semiconductor layer AS1 (see FIG. 10) has a shape that is bent multiple times such as a ' 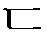 ' shape, a ' 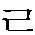 ' shape, an 'S' shape, an 'M' shape, or a 'W' shape, a long channel may be formed in a narrow space. Because the first channel region A1 is formed long, a driving range of a gate voltage applied to the first gate electrode G1 may be increased, a gray scale of light emitted from the organic light-emitting diode OLED may be more precisely controlled, and display quality may be improved. In some embodiments, the first semiconductor layer AS1 (see FIG. 10) may be provided in a straight shape, rather than a bent shape. The first gate electrode G1 may have an isolated shape and may overlap the first channel region A1 with the first gate insulating layer 113 (see FIG. 10) therebetween.

In an embodiment, the storage capacitor Cst may overlap the first transistor T1. The storage capacitor Cst may include the first storage electrode CE1 and the second storage electrode CE2. The first gate electrode G1 may function as a control electrode of the first transistor T1 and may also function as the first storage electrode CE1 of the storage capacitor Cst. That is, the first gate electrode G1 and the first storage electrode CE1 may be integrally formed with each other. The second storage electrode CE2 of the storage capacitor Cst may overlap the first storage electrode CE1 with the second gate insulating layer 114 (see FIG. 6) therebetween. In this case, the second gate insulating layer 114 (see FIG. 6) may function as a dielectric layer of the storage capacitor Cst.

In an embodiment, the second transistor T2 may include a second semiconductor and a second gate electrode G2. The second semiconductor layer may include a second channel region A2, a second source region S2 and a second drain region D2 on both sides of the second channel region A2. The second source region S2 may be electrically connected to the data line DL, and the second drain region D2 may be connected to the first source region S1. The second gate electrode G2 may be integrally provided with the scan line GWL.

In an embodiment, the fifth transistor T5 may include a fifth semiconductor layer and a fifth gate electrode G5. The fifth semiconductor layer may include a fifth channel region A5, a fifth source region S5 and a fifth drain region D5 on both sides of the fifth channel region A5. The fifth source region S5 may be electrically connected to the driving voltage line PL, and the fifth drain region D5 may be connected to the first source region S1. The fifth gate electrode G5 may be provided as a part of the emission control line EML.

In an embodiment, the sixth transistor T6 may include a sixth semiconductor layer and a sixth gate electrode G6. The sixth semiconductor layer may include a sixth channel region A6, a sixth source region S6 and a sixth drain region D6 on both sides of the sixth channel region A6. The sixth source region S6 may be connected to the first drain region D1, and the sixth drain region D6 may be electrically connected to the pixel electrode 310 (see FIG. 10) of the organic light-emitting diode OLED. The sixth gate electrode G6 may be provided as a part of the emission control line EML.

In an embodiment, the seventh transistor T7 may include a seventh semiconductor layer and a seventh gate electrode G7. The seventh semiconductor layer may include a seventh channel region A7, a seventh source region S7 and a seventh drain region D7 on both sides of the seventh channel region A7. The seventh drain region D7 may be electrically connected to the second initialization voltage wiring VIL2, and the seventh source region S7 may be connected to the sixth drain region D6. The seventh gate electrode G7 may be provided as a part of the next scan line GBL.

In an embodiment, in addition to the first, second, and fifth to seventh transistors T1, T2, T5, T6, and T7, respectively, including a silicon semiconductor, the third and fourth transistors T3 and T4, respectively, may include an oxide semiconductor and may be located on the substrate 100. Each of semiconductor layers of the third transistor T3 and the fourth transistor T4 may include a channel region, a source region and a drain region on both sides of the channel region. Each source region and each drain region may respectively correspond to a source electrode and a drain electrode. Hereinafter, the terms "source region" and "drain region" are used instead of the terms "source electrode" and "drain electrode".

In an embodiment, the third transistor T3 includes a third semiconductor layer including an oxide semiconductor and a third gate electrode G3. The third semiconductor layer includes a third channel region A3, a third source region S3 and a third drain region D3 on both sides of the third channel region A3. The third source region S3 may be bridge-connected to the first gate electrode G1 through a node connection line 181 (or 2-1 conductive pattern). Also, the third source region S3 may be connected to a fourth drain region D4 located on the same layer. The third drain region D3 may be electrically connected to the first semiconductor layer AS1 (see FIG. 10) of the first transistor T1 and the sixth semiconductor layer of the sixth transistor T6. The third gate electrode G3 may be provided as a part of the compensation gate line GCL.

In an embodiment, the fourth transistor T4 includes a fourth semiconductor layer AO4 including an oxide semiconductor and a fourth gate electrode G4. The fourth semiconductor layer AO4 (see FIG. 10) includes a fourth channel region A4, a fourth source region S4 and the fourth drain region D4 on both sides of the fourth channel region A4. The fourth source region S4 may be electrically connected to the first initialization voltage wiring VIL1, and the fourth drain region D4 may be bridge-connected to the first gate electrode G1 through the node connection line 181 (or the 2-1 conductive pattern). The fourth gate electrode G4 may be provided as a part of the initialization gate line GIL.

In an embodiment, the first boost electrode CE3 of the boost capacitor Cbt may be provided as a part of the scan line GWL, and may be connected to the second gate electrode G2. The second boost electrode CE4 of the boost capacitor Cbt may overlap the first boost electrode CE3 and may be formed of an oxide semiconductor. The second boost electrode CE4 may be provided on the same layer as the third semiconductor layer of the third transistor T3 and the fourth semiconductor layer AO4 (see FIG. 10) of the fourth transistor T4 and may be an area between the third semiconductor layer and the fourth semiconductor layer AO4 (see FIG. 10). Alternatively, the second boost electrode CE4 may extend from the fourth semiconductor layer. Alternatively, the second boost electrode CE4 may extend from the third semiconductor layer.

In an embodiment, some of the wirings may include two conductive layers located on different layers. For example, the initialization gate line GIL may include a lower initialization gate line 144 and an upper initialization gate line 155 located on different layers. The lower initialization gate line 144 may be formed of the same material on the same layer as the first gate electrode G1 and the first storage electrode CE1. The upper initialization gate line 155 may be formed of the same material on the same layer as the second storage electrode CE2 of the storage capacitor Cst. The lower initialization gate line 144 may at least partially overlap the upper initialization gate line 155.

Also, in an embodiment, the compensation gate line GCL may include a lower compensation gate line 143 and an upper compensation gate line 154 located on different layers. The lower compensation gate line 143 may be formed of the same material on the same layer as the first gate electrode G1 and the first storage electrode CE1. The upper compensation gate line 154 may be formed of the same material on the same layer as the second storage electrode CE2 of the storage capacitor Cst. The lower compensation gate line 143 may at least partially overlap the upper compensation gate line 154.

In an embodiment, the display apparatus 1 may have a structure in which the lower metal layer 120, the semiconductor layer 130, the gate layer 140, the first conductive layer 150, the second conductive layer 180, and the third conductive layer 190 are sequentially stacked.

First, in an embodiment, the lower metal layer 120 may include the same material as the lower metal layer 120 of FIG. 4. The lower metal layer 120 may include a first lower metal pattern 123 and a second lower metal pattern 124. The first lower metal pattern 123 may be a shield pattern located to correspond to the first transistor T1, and the second lower metal pattern 124 may be a connection wiring extending in the x direction and the y direction from the first lower metal pattern 123.

In an embodiment, the semiconductor layer 130 may be located on the lower metal layer 120. The semiconductor layer 130 may include a first semiconductor pattern 134 and a second semiconductor pattern 135. In this case, the first semiconductor pattern 134 may include the same material as the first peripheral semiconductor layer PA1 of FIG. 5. That is, the first semiconductor pattern 134 may include a silicon semiconductor. For example, the first semiconductor pattern 134 may include amorphous silicon and/or polysilicon.

In an embodiment, the second semiconductor pattern 135 may include the same material as the first semiconductor layer AO1 of FIG. 4. That is, the second semiconductor pattern 135 may include an oxide semiconductor. For example, the second semiconductor pattern 135 may include an oxide of at least one material selected from the group consisting of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). For example, the second semiconductor pattern 135 may be an InSnZnO (ITZO) semiconductor layer or an InGaZnO (IGZO) semiconductor layer. When necessary, a conductive process by plasma treatment or the like may be performed on at least a part of the semiconductor layer 130.

In an embodiment, the first semiconductor pattern 134 may include the first semiconductor layer AS1 of the first transistor T1, the second semiconductor layer of the second transistor T2, the fifth semiconductor layer of the fifth transistor T5, the sixth semiconductor layer of the sixth transistor T6, and the seventh semiconductor layer of the seventh transistor T7. The semiconductor layers of the first transistor T1, the second transistor T2, the fifth transistor T5, the sixth transistor T6, and the seventh transistor T7 may be connected to each other to form one semiconductor layer.

In an embodiment, the second semiconductor pattern 135 may include the third semiconductor layer of the third transistor T3 and the fourth semiconductor layer AO4 (see FIG. 10) of the fourth transistor T4. The second semiconductor pattern 135 may be spaced apart from the first semiconductor pattern 134 in a plan view.

In an embodiment, the gate layer 140 may be located on the semiconductor layer 130. The gate layer 140 may include the same material as the gate layer 140 of FIG. 4. The gate layer 140 may include the emission control line EML, a lower initialization gate line 144, a lower compensation gate line 143, the scan line GWL, and the first gate electrode G1. The first gate electrode G1 may be provided in an isolated shape, and the emission control line EML, the lower initialization gate line 144, the lower compensation gate line 143, and the scan line GWL may extend in the x axis direction.

In an embodiment, the first conductive layer 150 may be located on the gate layer 140. The first conductive layer 150 may include the same material as the first conductive layer 150 of FIG. 4. The first conductive layer 150 may include an upper compensation gate line 154, an upper initialization gate line 155, the first initialization voltage wiring VIL, and the second storage electrode CE2. The second storage electrode CE2 may include an opening and may have an isolated shape. That is, the opening of the second storage electrode CE2 may be formed by removing a part of the second storage electrode CE2, and may have a closed shape. The upper compensation gate line 154, the upper initialization gate line 155, and the first initialization voltage wiring VIL1 may extend in the x axis direction.

In an embodiment, the second conductive layer 180 may be located on the first conductive layer 150. The second conductive layer 180 may include the same material as the second conductive layer 160 of FIG. 4. The second conductive layer 180 may include the 2-1 conductive pattern 181, a 2-2 conductive pattern 182, a 2-3 conductive pattern 183, a 2-4 conductive pattern 184, a 2-5 conductive pattern 185, and the second initialization voltage wiring VIL2. The second initialization voltage wiring VIL2 may extend in the x axis direction. The 2-1 conductive pattern 181 may extend in the y axis direction and may include one end connected to the first gate electrode G1 through a contact hole and the other end connected to the third semiconductor layer. The 2-2 conductive pattern 182 may be connected to the second storage electrode CE2 of the storage capacitor Cst through a contact hole. The 2-3 conductive pattern 183 may have an isolated shape, may be connected to the first semiconductor pattern 134 through a contact hole, and may be connected to the third conductive layer 190 through another contact hole. The 2-4 conductive pattern 184 may have an isolated shape and may include one end connected to the first semiconductor pattern 134 through a contact hole and the other end connected to the second semiconductor pattern 135 through a contact hole. The 2-5 conductive pattern 185 may have an isolated shape and may be connected to the first semiconductor pattern 134 through a contact hole and may be connected to the third conductive layer 190 through another contact hole.

In an embodiment, the third conductive layer 190 may be located on the second conductive layer 180. The third conductive layer 190 may include the same material as the third conductive layer 170 of FIG. 4. The third conductive layer 190 may include a 3-1 conductive pattern 191, a 3-2 conductive pattern 192, and a 3-3 conductive pattern 193. The 3-1 conductive pattern 191 may have an isolated shape and may include one end connected to the second conductive layer 180 through a contact hole and the other end connected to the organic light-emitting diode OLED (see FIG. 10) through a contact hole. The 3-2 conductive pattern 192 may correspond to the driving voltage line PL, and the 3-3 conductive pattern 193 may correspond to the data line DL.

FIG. 10 is a cross-sectional view schematically illustrating parts of a display apparatus, 1 according to another embodiment. FIG. 10 is a schematic cross-sectional view taken along line IV-IV' of FIG. 9, taken along line II-II' of FIG. 5, and taken along line III-III' of FIG. 5.

In an embodiment and referring to FIG. 10, the lower metal layer 120 may be located between the first barrier layer 110a and the second barrier layer 110b. The lower metal layer 120 may include the first lower metal pattern 123 located to correspond to the first transistor T1. In another embodiment, the lower metal layer 120 may be located between the second barrier layer 110b and the buffer layer 111.

In an embodiment and as shown in FIG. 10, the first peripheral semiconductor layer PA1 of the first peripheral transistor PT1 (see FIG. 5) and the buffer semiconductor layer BA1 of the buffer transistor BF (see FIG. 5) may be located on the buffer layer 111. Also, a semiconductor layer of a silicon-based thin-film transistor such as the first transistor T1, for example, the first semiconductor layer AS1, may be located on the buffer layer 111. The first peripheral semiconductor layer PA1, the buffer semiconductor layer BA1, the first semiconductor layer AS1, the second semiconductor layer, the fifth semiconductor layer, the sixth semiconductor layer, and the seventh semiconductor layer may be located on the same layer and may include a silicon semiconductor.

In an embodiment, the insulating layer 112 may be located to cover the first peripheral semiconductor layer PA1, the buffer semiconductor layer BA1, and the first semiconductor layer AS1. The insulating layer 112 may include the same material as the insulating layer 112 of FIG. 6.

In an embodiment, the third semiconductor layer of the third transistor T3 (see FIG. 9) and the fourth semiconductor layer AO4 of the fourth transistor T4 may be located on the insulating layer 112. Each of the third semiconductor layer and the fourth semiconductor layer AO4 may include an oxide semiconductor as described above.

In an embodiment, the insulating layer 112 may be located between the first semiconductor layer AS1 and the fourth semiconductor layer AO4. That is, the third semiconductor layer and the fourth semiconductor layer AO4 including an oxide semiconductor may be located on the first peripheral semiconductor layer PA1, the buffer semiconductor layer BA1, and the first semiconductor layer AS1 including a silicon semiconductor. In other words, the insulating layer 112 may be located on the first semiconductor layer AS1 including a silicon semiconductor, and the fourth semiconductor layer AO4 including an oxide semiconductor may be located on the insulating layer 112.

In an embodiment, the first gate insulating layer 113 may be located on the first semiconductor layer AS1 and the second semiconductor layer AS2. The first gate insulating layer 113 may include the same material as the first gate insulating layer 113 of FIG. 6.

In an embodiment, the first gate electrode G1, the lower compensation gate line 143, the first boost electrode CE3, the fourth gate electrode G4, the first peripheral gate electrode PG1, and the first branch control electrode BCE1 may be located on the first gate insulating layer 113. The first gate electrode G1 may be integrally formed with the first storage electrode CE1. The first gate electrode G1, the lower compensation gate line 143, the first boost electrode CE3, the fourth gate electrode G4, the first peripheral gate electrode PG1, and the first branch control electrode BCE1 may be located on substantially the same layer and may include the same material. The first gate electrode G1, the lower compensation gate line 143, the first boost electrode CE3, the fourth gate electrode G4, the first peripheral gate electrode PG1, and the first branch control electrode BCE1 may include the same material as the first gate layer 140 of FIG. 4.

That is, in an embodiment, although a transistor including an oxide-based semiconductor layer and a transistor including a silicon-based semiconductor layer are used, and semiconductor layers are located on different layers, gate electrodes of the transistors may be located on the same layer. Accordingly, even according to the display apparatus 1 of another embodiment, the number of masks required in a process of forming an additional gate may be reduced and a process step may be simplified, thereby reducing costs.

In an embodiment, the second gate insulating layer 114 may be located on the gate electrodes. The second gate insulating layer 114 may include the same material as the second gate insulating layer 114 of FIG. 6.

In an embodiment and as shown in FIG. 10, the second storage electrode CE2, the upper compensation gate line 154, the upper initialization gate line 155, and the connection electrode 153 may be located on the second gate insulating layer 114. In this case, the second storage electrode CE2 may overlap the first storage electrode CE1, to form the storage capacitor Cst. The upper compensation gate line 154 may partially overlap the lower compensation gate line 143, and the upper initialization gate line 155 may also partially overlap the fourth gate electrode G4. The second storage electrode CE2, the upper compensation gate line 154, the upper initialization gate line 155, and the connection electrode 153 may include the same material as the first conductive layer 150 of FIG. 4.

In an embodiment, the first interlayer insulating layer 115 may be located on the second storage electrode CE2, the upper compensation gate line 154, the upper initialization gate line 155, and the connection electrode 153. The first interlayer insulating layer 115 may include the same material as the first interlayer insulating layer 115 of FIG. 6.

In an embodiment, the node connection line 181 (or the 2-1 conductive pattern), the 2-2 conductive pattern 182, the connection electrodes 167 and 168, the first branch input electrode BIE1, and the first branch output electrode BOE1 may be located on the first interlayer insulating layer 115. The node connection line 181, the 2-2 conductive pattern 182, and the connection electrodes 167 and 168 may include the same material as the second conductive layer 160 of FIG. 4.

In an embodiment, the first planarization layer 116 may be located on the 2-1 conductive pattern 181, the 2-2 conductive pattern 182, and the connection electrodes 167 and 168, and the third conductive layer 190 (see FIG. 9) may be located on the first planarization layer 116. The third conductive layer 190 (see FIG. 9) may include the 3-2 conductive pattern 192, the 3-3 conductive pattern 193, and the clock wiring CKL. That is, the driving voltage line PL (see FIG. 9) and the data line DL (see FIG. 9) may be located on the first planarization layer 116. The third conductive layer 190 (see FIG. 9) may include the same material as the third conductive layer 170 of FIG. 4.

In an embodiment, the second planarization layer 117 may be located on the third conductive layer 190. The first planarization layer 116 and the second planarization layer 117 may include the same material as the first planarization layer 116 and the second planarization layer 117 of FIG. 6. The bank layer 118 and the organic light-emitting diode OLED located on the second planarization layer 117 may also have the same structure and may include the same material as the bank layer 118 and the organic light-emitting diode OLED described with reference to FIG. 6.

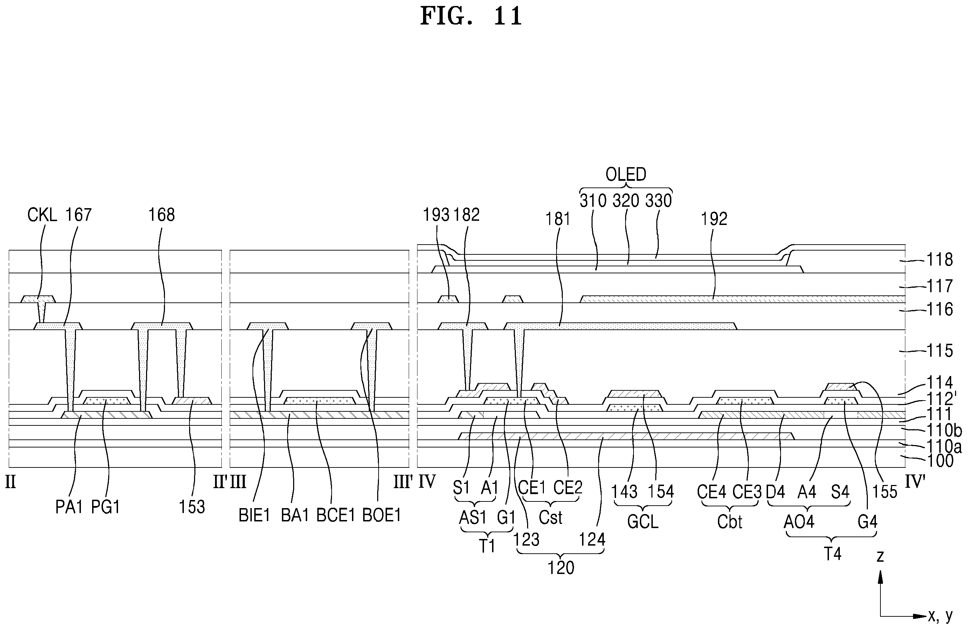

FIG. 11 is a cross-sectional view schematically illustrating parts of a display apparatus 1, according to another embodiment. Referring to FIG. 11, characteristics other than characteristics of semiconductor layers (e.g., AS1, AO4, PA1, and BA1) and the first gate insulating layer 112' are the same as those described with reference to FIGS. 9 and 10. In FIGS. 11, and 9 and 10, the same elements are denoted by the same reference numerals and a repeated description thereof will not be given, and the following will focus on a difference.

In an embodiment and referring to FIG. 11, not only the first peripheral semiconductor layer PA1, the buffer semiconductor layer BA1, and the first semiconductor layer AS1 but also the fourth semiconductor layer AO4 may be located on the buffer layer 111. That is, although the fourth semiconductor layer AO4 including an oxide semiconductor, and the first peripheral semiconductor layer PA1, the buffer semiconductor layer BA1, and the first semiconductor layer AS1 including a silicon semiconductor include different materials, the fourth semiconductor layer AO4, and the first peripheral semiconductor layer PA1, the buffer semiconductor layer BA1, and the first semiconductor layer AS1 may be located on substantially the same layer. In other words, semiconductor layers included in the first to seventh transistors T1, T2, T3, T4, T5, T6, and T7 (see FIG. 9), respectively, may be located on the same layer.

In an embodiment, the first gate insulating layer 112' may be located on the semiconductor layers. The first gate insulating layer 112' may include an inorganic material including oxide and/or nitride. For example, the first gate insulating layer 112' may include at least one of silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), and zinc oxide (ZnO₂).

In an embodiment, the first gate electrode G1, the lower compensation gate line 143, the first boost electrode CE3, the fourth gate electrode G4, the first peripheral gate electrode PG1, and the first branch control electrode BCE1 may be located on the first gate insulating layer 112'. The first gate electrode G1, the lower compensation gate line 143, the first boost electrode CE3, the fourth gate electrode G4, the first peripheral gate electrode PG1, and the first branch control electrode BCE1 may be located on substantially the same layer and may include the same material.

That is, in an embodiment, only the first gate insulating layer 112' may be located between the first semiconductor layer AS1 and the first gate electrode G1, and only the first gate insulating layer 112' may be located between the fourth semiconductor layer AO4 and the fourth gate electrode G4. As shown in FIG. 11, when one insulating layer is located between the first semiconductor layer AS1 and the first gate electrode G1, the first transistor T1 that is a driving transistor may have excellent electrical characteristics. In addition, in the display apparatus 1 of FIG. 11, because the insulating layer 112 (see FIG. 10) that may be located between the first peripheral semiconductor layer PA1 and the first semiconductor layer AS1 is not located, a step of forming an insulating layer may be excluded, a process may be simplified, and costs may be reduced.

In addition, in an embodiment, as described with reference to FIG. 6, because gate electrodes are all located on the same layer, the number of masks required for an additional gate layer may be reduced by 1, and a process of forming an additional gate electrode may be excluded. Accordingly, according to the display apparatus 1 of another embodiment as shown in FIG. 11, excellent electrical characteristics may be ensured and costs may be more dramatically reduced.

A display apparatus 1 according to an embodiment as described above may provide a high-quality image and may reduce costs by simplifying a process. These effects are examples, and do not limit the scope of the invention.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by one of ordinary skill in the art that various changes in form and details may be made therein without departing from the scope as defined by the following claims. Moreover, embodiments or parts of the embodiments may be combined in whole or in part without departing from the scope of the invention.

## Claims

1. A display apparatus (1) comprising:
a substrate (100) comprising a display area (DA) and a peripheral area (PA) surrounding the display area (DA);
a first silicon-based transistor (PT1) located on the substrate (100), and comprising a first semiconductor layer (PA1) comprising a silicon semiconductor and a first gate electrode (PG1) insulated from the first semiconductor layer (PA1);
a first oxide-based transistor (T1) located on the substrate (100), and comprising a second semiconductor layer (AO1) comprising an oxide semiconductor and a second gate electrode (G1) insulated from the second semiconductor layer (AO1); and
a first gate insulating layer (113) located on the first semiconductor layer (PA1) and the second semiconductor layer (AO1),
the first gate electrode (PG1) and the second gate electrode (G1) are located on the first gate insulating layer (113) and are located on a same layer;
a driving circuit (1300, 1310) located in the peripheral area (PA), the driving circuit (1300, 1310) comprises the first silicon-based transistor (PT1);
a pixel circuit (PC) located in the display area (DA), the pixel circuit (PC) comprises the first oxide-based transistor (T1);
a first storage electrode (CEs1) integrally formed with the second gate electrode (G1);
a second gate insulating layer (114) covering the first gate electrode (PG1) and the second gate electrode (G1); and
a second storage electrode (CEs2) formed on the second gate insulating layer (114) and overlapping the first storage electrode (CEs1),
the pixel circuit (PC) further comprises a storage capacitor (Cst) connected between a first node (N1) which is connected to the first gate of the first oxide-based transistor (T1) and a second node (N2) which is connected to one terminal of the first oxide-based transistor (T1), and comprising the first storage electrode (CEs1) and the second storage electrode (CEs2); and wherein the display apparatus (1) further comprising:
a first hold electrode (CEh1) formed on a same layer as the second storage electrode (CEs2);
a second hold electrode (CEh2) formed on a same layer as the second gate electrode (G1); and
the pixel circuit (PC) further comprises a hold capacitor (Chd) connected between a driving voltage line (PL) and the second node (N2), and comprising the first hold electrode (CEh1) and the second hold electrode (CEh2).

2. The display apparatus of claim 1, wherein the first silicon-based transistor (PT1) is located in the peripheral area (PA) of the substrate (100), and the first oxide-based transistor (T1) is located on the display area (DA) of the substrate (100).

3. The display apparatus of claim 1 or 2, further comprising an insulating layer (112) located between the first semiconductor layer (PA1) and the second semiconductor layer (A01).

4. The display apparatus of claim 3, wherein
the insulating layer (112) and the first gate insulating layer (113) are located between the first semiconductor layer (PA1) and the first gate electrode (PG1), and
wherein only the first gate insulating layer (113) is located between the second semiconductor layer (AO1) and the second gate electrode (G1).

5. The display apparatus of claim 1 or 2, wherein the first semiconductor layer (PA1) and the second semiconductor layer (AO1) are located on a same layer.

6. The display apparatus of claim 5, wherein
only the first gate insulating layer (113) is located between the first semiconductor layer (PA1) and the first gate electrode (PG1), and
only the first gate insulating layer (113) is located between the second semiconductor layer (AO1) and the second gate electrode (G1).

## Patentansprüche

1. Anzeigegerät (1), umfassend:
ein Substrat (100) mit einem Anzeigebereich (DA) und einem den Anzeigebereich (DA) umgebenden Umfangsbereich (PA);
einen ersten Transistor auf Siliziumbasis (PT1), der sich auf dem Substrat (100) befindet und eine erste Halbleiterschicht (PA1), die einen Siliziumhalbleiter umfasst, und eine erste Gate-Elektrode (PG1), die von der ersten Halbleiterschicht (PA1) isoliert ist, umfasst;
einen ersten Transistor auf Oxidbasis (T1), der sich auf dem Substrat (100) befindet und eine zweite Halbleiterschicht (AO1), die einen Oxidhalbleiter umfasst, und eine zweite Gate-Elektrode (G1), die von der zweiten Halbleiterschicht (AO1) isoliert ist, umfasst; und
eine erste Gate-Isolierschicht (113), die sich auf der ersten Halbleiterschicht (PA1) und der zweiten Halbleiterschicht (AO1) befindet,
die erste Gate-Elektrode (PG1) und die zweite Gate-Elektrode (G1) auf der ersten Gate-Isolierschicht (113) angeordnet sind und sich auf derselben Schicht befinden;
eine Treiberschaltung (1300, 1310), die sich im Umfangsbereich (PA) befindet, wobei die Treiberschaltung (1300, 1310) den ersten Transistor auf Siliziumbasis (PT1) umfasst;
eine Pixelschaltung (PC), die sich im Anzeigebereich (DA) befindet, wobei die Pixelschaltung (PC) den ersten Transistor auf Oxidbasis (T1) umfasst;
eine erste Speicherelektrode (CEs1), die integral mit der zweiten Gate-Elektrode (G1) ausgebildet ist;
eine zweite Gate-Isolierschicht (114), die die erste Gate-Elektrode (PG1) und die zweite Gate-Elektrode (G1) bedeckt; und
eine zweite Speicherelektrode (CEs2), die auf der zweiten Gate-Isolierschicht (114) ausgebildet ist und die erste Speicherelektrode (CEs1) überlappt,
die Pixelschaltung (PC) ferner einen Speicherkondensator (Cst) umfasst, der zwischen einem ersten Knoten (N1), der mit dem ersten Gate des ersten Transistors auf Oxidbasis (T1) verbunden ist, und einem zweiten Knoten (N2), der mit einem Anschluss des ersten Transistors auf Oxidbasis (T1) verbunden ist, geschaltet ist und die erste Speicherelektrode (CEs1) und die zweite Speicherelektrode (CEs2) umfasst; und wobei das Anzeigegerät (1) ferner Folgendes umfasst:
eine erste Halteelektrode (CEh1), die auf derselben Schicht wie die zweite Speicherelektrode (CEs2) ausgebildet ist;
eine zweite Halteelektrode (CEh2), die auf derselben Schicht wie die zweite Gate-Elektrode (G1) ausgebildet ist; und
die Pixelschaltung (PC) ferner einen Haltekondensator (Chd) umfasst, der zwischen einer Treiberspannungsleitung (PL) und dem zweiten Knoten (N2) geschaltet ist und die erste Halteelektrode (CEh1) und die zweite Halteelektrode (CEh2) umfasst.

2. Anzeigegerät nach Anspruch 1, wobei sich der erste Transistor auf Siliziumbasis (PT1) im Umfangsbereich (PA) des Substrats (100) und der erste Transistor auf Oxidbasis (T1) auf dem Anzeigebereich (DA) des Substrats (100) befindet.

3. Anzeigegerät nach Anspruch 1 oder 2, umfassend ferner eine zwischen der ersten Halbleiterschicht (PA1) und der zweiten Halbleiterschicht (AO1) befindliche Isolierschicht (112).

4. Anzeigegerät nach Anspruch 3, wobei
sich die Isolierschicht (112) und die erste Gate-Isolierschicht (113) zwischen der ersten Halbleiterschicht (PA1) und der ersten Gate-Elektrode (PG1) befinden, und
wobei sich nur die erste Gate-Isolierschicht (113) zwischen der zweiten Halbleiterschicht (AO1) und der zweiten Gate-Elektrode (G1) befindet.

5. Anzeigegerät nach Anspruch 1 oder 2, wobei sich die erste Halbleiterschicht (PA1) und die zweite Halbleiterschicht (AO1) auf derselben Schicht befinden.

6. Anzeigegerät nach Anspruch 5, wobei
sich nur die erste Gate-Isolierschicht (113) zwischen der ersten Halbleiterschicht (PA1) und der ersten Gate-Elektrode (PG1) befindet, und
sich nur die erste Gate-Isolierschicht (113) zwischen der zweiten Halbleiterschicht (AO1) und der zweiten Gate-Elektrode (G1) befindet.

## Revendications

1. Appareil d'affichage (1) comportant :
un substrat (100) comportant une zone d'affichage (DA) et une zone périphérique (PA) encerclant la zone d'affichage (DA) ;
un premier transistor à base de silicium (PT1) situé sur le substrat (100), et comportant une première couche de semi-conducteur (PA1) comportant un semi-conducteur au silicium et une première électrode de grille (PG1) isolée de la première couche de semi-conducteur (PA1) ;
un premier transistor à base d'oxyde (T1) situé sur le substrat (100), et comportant une deuxième couche de semi-conducteur (AO1) comportant un semi-conducteur à oxyde et une deuxième électrode de grille (G1) isolée de la deuxième couche de semi-conducteur (AO1) ; et
une première couche isolante de grille (113) située sur la première couche de semi-conducteur (PA1) et la deuxième couche de semi-conducteur (AO1),
la première électrode de grille (PG1) et la deuxième électrode de grille (G1) sont situées sur la première couche isolante de grille (113) et sont situées sur une même couche ;
un circuit d'excitation (1300, 1310) situé dans la zone périphérique (PA), le circuit d'excitation (1300, 1310) comportant le premier transistor à base de silicium (PT1) ;
un circuit de pixels (PC) situé dans la zone d'affichage (DA), le circuit de pixels (PC) comportant le premier transistor à base d'oxyde (T1) ;
une première électrode de stockage (CEs1) formée d'un seul tenant avec la deuxième électrode de grille (G1) ;
une deuxième couche isolante de grille (114) recouvrant la première électrode de grille (PG1) et la deuxième électrode de grille (G1) ; et
une deuxième électrode de stockage (CEs2) formée sur la deuxième couche isolante de grille (114) et chevauchant la première électrode de stockage (CEs1),
le circuit de pixels (PC) comporte en outre un condensateur de stockage (Cst) connecté entre un premier nœud (N1) qui est connecté à la première grille du premier transistor à base d'oxyde (T1) et un deuxième nœud (N2) qui est connecté à une borne du premier transistor à base d'oxyde (T1), et comportant la première électrode de stockage (CEs1) et la deuxième électrode de stockage (CEs2) ; et dans lequel l'appareil d'affichage (1) comporte en outre :
une première électrode de maintien (CEh1) formée sur une même couche que la deuxième électrode de stockage (CEs2) ;
une deuxième électrode de maintien (CEh2) formée sur une même couche que la deuxième électrode de grille (G1) ; et
le circuit de pixels (PC) comporte en outre un condensateur de maintien (Chd) connecté entre une ligne de tension d'excitation (PL) et le deuxième nœud (N2), et comportant la première électrode de maintien (CEh1) et la deuxième électrode de maintien (CEh2).

2. Appareil d'affichage selon la revendication 1, dans lequel le premier transistor à base de silicium (PT1) est situé dans la zone périphérique (PA) du substrat (100), et le premier transistor à base d'oxyde (T1) est situé sur la zone d'affichage (DA) du substrat (100).

3. Appareil d'affichage selon la revendication 1 ou 2, comportant en outre une couche isolante (112) située entre la première couche de semi-conducteur (PA1) et la deuxième couche de semi-conducteur (AO1).

4. Appareil d'affichage selon la revendication 3, dans lequel
la couche isolante (112) et la première couche isolante de grille (113) sont situées entre la première couche de semi-conducteur (PA1) et la première électrode de grille (PG1), et
dans lequel seule la première couche isolante de grille (113) est située entre la deuxième couche de semi-conducteur (AO1) et la deuxième électrode de grille (G1).

5. Appareil d'affichage selon la revendication 1 ou 2, dans lequel la première couche de semi-conducteur (PA1) et la deuxième couche de semi-conducteur (AO1) sont situées sur une même couche.

6. Appareil d'affichage selon la revendication 5, dans lequel
seule la première couche isolante de grille (113) est située entre la première couche de semi-conducteur (PA1) et la première électrode de grille (PG1), et
seule la première couche isolante de grille (113) est située entre la deuxième couche de semi-conducteur (AO1) et la deuxième électrode de grille (G1).
